# EUROPÄISCHE PATENTSCHRIFT

(11) **EP 4 338 182 B1**
(45) Veröffentlichungstag und Bekanntmachung des Hinweises auf die Patenterteilung: **06.08.2025**
(21) Anmeldenummer: 22728484.1
(22) Anmeldetag: 10.05.2022
(51) Int. Cl.: H01H 9/16, G01R 31/327, H01H 47/00

(54) **KONTAKTÜBERWACHUNGSVORRICHTUNG FÜR EINEN DREIPOLIGEN WECHSELKONTAKT**
CONTACT MONITORING APPARATUS FOR A THREE-POLE CHANGEOVER CONTACT
APPAREIL DE SURVEILLANCE DE CONTACT POUR UN CONTACT DE COMMUTATION TRIPOLAIRE

(30) Priorität: 12.05.2021 BE 202105383
(43) Veröffentlichungstag der Anmeldung: 20.03.2024
(73) Patentinhaber: PHOENIX CONTACT GmbH & Co. KG, 32825 Blomberg (DE)
(72) Erfinder: REINHOLD, Christian, 31785 Hameln (DE); SCHOLZ, Peter, 33034 Brakel (DE)
(74) Vertreter: LifeTech IP Spies & Behrndt Patentanwälte PartG mbB
(86) Internationale Anmeldenummer: PCT/EP2022/062552
(87) Internationale Veröffentlichungsnummer: WO 2022/238361

(56) Entgegenhaltungen:
- EP-A1- 1 202 313
- CN-A- 109 283 462

## Beschreibung

Die Erfindung betrifft eine Kontaktüberwachungseinrichtung zur Überwachung eines elektrischen, dreipoligen Wechslerkontakts (z. B. eines Relais), insbesondere zur Überwachung eines Schaltvorgangs des Wechslerkontakts.

Im Stand der Technik sind Wechslerkontakte mit drei Anschlüssen grundsätzlich bekannt, wobei die Anschlüsse zumeist als COM-Anschluss ("common"), NC-Anschluss ("normally closed") und NO-Anschluss ("normally open") bezeichnet werden. Ein Wechslerkontakt hat typischerweise die Aufgabe, einen elektrischen Kontakt zwischen einem gemeinsamen Anschluss, dem COM-Anschluss, und einem der zwei weiteren Anschlüsse, dem NC- oder NO-Anschluss, herzustellen. Im Normalbetrieb weist der Wechslerkontakt somit zwei Betriebszustände auf, nämlich entweder ist der COM-Anschluss mit dem NC-Anschluss verbunden oder der COM-Anschluss ist mit dem NO-Anschluss verbunden.

Neben den beiden vorgenannten Zuständen, welche auch im Falle eines gestörten Betriebs des Wechslerkontakts auftreten können (z. B. wenn der COM-Anschluss und der NC- bzw. NO-Anschluss miteinander verschweißt sind), können im Fehlerfall auch weitere Schaltzustände auftreten. So kann z. B. infolge verschlissener Kontaktperlen keinerlei Verbindung zwischen den drei Anschlüssen bestehen. Alternativ können auch alle drei Anschlüsse miteinander verbunden sein, beispielsweise durch einen Lichtbogen oder durch ein Verschweißen der Kontakte infolge thermischer und/oder elektrischer Überlastung. Weiterhin kann auch der NC Anschluss nur mit dem NO-Anschluss verbunden sein, aber beide jeweils nicht mit dem COM-Anschluss, wobei dieser Zustand aufgrund des Aufbaus eines Relais typischerweise eine eher untergeordnete Rolle spielt. Insgesamt können damit eine Reihe von (Fehl-)Zuständen bei Wechslerkontakten auftreten, weshalb in der Praxis ein Bedarf an einer einfachen und zuverlässigen Möglichkeit zur Erfassung bzw. Überwachung des Schaltzustands eines Wechslerkontakts besteht.

Das Dokument CN 109283462 A offenbart ein tragbares Prüfgerät für Relais, das ein Steuermodul, ein Antriebsmodul und ein Kontaktdetektionsmodul umfasst. Über PWM-Signale wird die Relaisspule bestromt, während ein Kontaktdetektionsschaltkreis die Schaltzustände und Kontaktwiderstände ermittelt. Die Messresultate werden im Steuermodul ausgewertet und beispielsweise anhand einer Anzeige und akustischer Signale dargestellt.

Aus der DE 28 06 294 A1 ist dabei das Prinzip bekannt, durch Aufprägen eines Prüfsignals auf einen Kontakt, dessen Schaltzustand auszuwerten. Allerdings handelt es sich bei dem dortigen Kontakt lediglich um einen Kontakt mit zwei Schaltzuständen.

Aus der EP 1 202 313 A1 ist ferner ein Verfahren zur Überwachung einer Schalterstellung mechanischer Schaltkontakte bekannt, wobei das Verfahren zwei Koppeltransformatoren erfordert. Weiterhin können mit dem vorgenannten Verfahren lediglich zwei Schaltzuständen unterschieden werden.

Ähnliche Lösungen zur Wechslerkontaktüberwachung sind auch aus den Dokumenten EP 3 396 692 A1, DE 27 29 480 A1, DE 42 21 916 A1 und DE 10 2018 217 135 A1 bekannt. Nachteilig an allen diesen Ansätzen ist jedoch, dass mit diesen jeweils nur zwei Schalterstellungen unterschieden werden können. Insbesondere im Fall des Ansatzes der DE 10 2018 217 135 A1 würde dabei der Zustand, dass alle drei Anschlüsse, d. h. der COM-, NC- und NO-Anschluss, miteinander verbunden sind (z. B. durch ein Verschweißen der Kontakte), fälschlicherweise als eine korrekte Funktion des Schalters interpretiert werden, obwohl ein Fehlerfall vorliegen kann.

Entsprechend ist es Aufgabe der Erfindung eine möglichst kostengünstige Möglichkeit zur Überwachung eines dreipoligen Wechslerschalters bereitzustellen, mit der die Nachteile der bisherigen Lösungen vermieden werden. Insbesondere ist es eine Aufgabe der Erfindung, eine Lösung bereitzustellen, mittels derer möglichst viele Fehl- bzw. Schaltzustände eines Wechslerschalters, vorzugsweise unabhängig von einer äußeren Beschaltung des Wechslerkontaktes, erkannt werden können.

Diese Aufgaben können mit den Merkmalen des unabhängigen Anspruchs 1 gelöst werden. Vorteilhafte Ausführungsformen und Anwendungen der Erfindung sind Gegenstand der abhängigen Ansprüche und werden in der folgenden Beschreibung unter teilweiser Bezugnahme auf die Figuren näher erläutert.

Gemäß einem ersten Aspekt betrifft die Offenbarung eine Kontaktüberwachungseinrichtung zur Überwachung eines elektrischen, dreipoligen Wechslerkontakts (z. B. eines Relais-Wechslerkontakts). Der Wechslerkontakt kann dabei drei Anschlüsse umfassen, welche im Folgenden als COM-Anschluss, NC-Anschluss und NO-Anschluss bezeichnet werden sollen.

Die Kontaktüberwachungseinrichtung umfasst einen Signalgenerator, der ausgebildet ist, ein Überwachungssignal zu erzeugen. Der Signalgenerator kann dabei beispielsweise eine Oszillatorschaltung, z. B. eine Colpitts-Oszillatorschaltung, sein. Vorzugsweise ist das Überwachungssignal ein hochfrequentes Überwachungssignal, d. h. ein Signal im Hochfrequenzbereich. Beispielsweise kann das Überwachungssignal eine Frequenz von mindestens 10 kHz, vorzugsweise von mindestens 100 kHz, oder weiter vorzugsweise von mindestens 1 MHz aufweisen. Vorzugsweise handelt es sich bei dem Überwachungssignal um ein Spannungssignal, jedoch kann das Überwachungssignal zudem oder alternativ auch ein Stromsignal und/oder ein Leistungssignal sein.

Ferner umfasst die Kontaktüberwachungseinrichtung eine, vorzugsweise ausschließlich eine, Koppeleinrichtung (z. B. einen Transformator), welche dem Signalgenerator nachgeschaltet ist und eine Sensierschaltung, welche der Koppeleinrichtung nachgeschaltet ist. D. h. mit anderen Worten ist die Sensierschaltung über die Koppeleinrichtung mit dem Signalgenerator, gekoppelt. Vorzugsweise ist die Koppeleinrichtung dabei eine induktive Koppeleinrichtung und/oder ausgebildet, die Sensierschaltung vom Signalgenerator, galvanisch zu trennen. Die Sensierschaltung ist wiederum an den Wechslerkontakt gekoppelt oder an diesen koppelbar. Vorzugsweise ist die Sensierschaltung dabei an jeden Anschluss des Wechslerkontakt gekoppelt oder an diesen koppelbar.

Hierbei ist vorgesehen, dass mittels der, über die Koppeleinrichtung mit dem Signalgenerator, gekoppelten, Sensierschaltung die Überwachungssignalerzeugung des Signalgenerators und damit das Überwachungssignal und/oder ein vom Überwachungssignal abgeleiteten Signals in Abhängigkeit einer Schaltstellung des Wechslerkontakts veränderbar ist. Mit anderen Worten kann die Sensierschaltung ausgebildet sein, über deren Kopplung mit dem Signalgenerator über die Koppeleinrichtung die Überwachungssignalerzeugung des Signalgenerators und damit das Überwachungssignal und/oder ein vom Überwachungssignal abgeleiteten Signal in Abhängigkeit einer Schaltstellung des Wechslerkontakts zu verändern. Lediglich beispielhaft kann die Sensierschaltung z. B. dazu ausgebildet sein, durch eine Beeinflussung des Schwingungsverhaltens des Signalgenerators die Amplitude und/oder Frequenz des erzeugten Überwachungssignals und/oder des vom Überwachungssignal abgeleiteten Signals in Abhängigkeit der Schaltstellung des Wechslerkontakts zu verändern. Unter einem vom Überwachungssignal abgeleiteten Signal soll dabei ein Signal verstanden werden, welches in einem funktionalen Zusammenhang mit dem Überwachungssignal steht (z.B. proportional dazu ist) und/oder aus diesem erzeugt bzw. umgewandelt werden kann. Beispielsweise kann das Überwachungssignal ein Spannungssignal und das vom Überwachungssignal abgeleiteten Signal ein Stromsignal sein. Ferner ist die Sensierschaltung dazu ausgebildet, das Überwachungssignal und/oder das vom Überwachungssignal abgeleitete Signal für zumindest drei, vorzugsweise vier, besonders bevorzugt fünf, verschiedene Schalterstellungen des Wechslerkontakts unterschiedlich zu verändern. Unter "Verändern" kann hierbei allgemein auch ein "Beeinflussen" oder "Variieren" verstanden werden.

Mit anderen Worten kann für jede der Schalterstellungen eine für die jeweilige Schalterstellung charakteristische Veränderung bzw. Beeinflussung des Überwachungssignals erfolgen, welche sodann z. B. in einer für jede der Schalterstellungen unterschiedlichen Amplitude des Überwachungssignals resultiert.

Weiterhin umfasst die Kontaktüberwachungseinrichtung eine Auswerteeinrichtung, welche ausgebildet ist, das Überwachungssignal und/oder das vom Überwachungssignal abgeleitete Signal und/oder eine Änderung des Überwachungssignals und/oder eine Änderung des vom Überwachungssignal abgeleiteten Signals zu erfassen, um dadurch den Wechslerkontakt zu überwachen. Beispielsweise kann die Auswerteeinrichtung die aktuelle Amplitude des Überwachungssignals und/oder eine Amplitudenänderung des Überwachungssignals erfassen und auf Grundlage dessen z. B. den aktuellen Ist-Schaltzustand des Wechslerkontakts bestimmen, welcher sodann wiederum z. B. mit einem vorgegebenen Soll-Schaltzustand verglichen werden kann. Im Fall, dass das Überwachungssignals ein impulsartiges Überwachungssignal ist, kann das Erfassen einer Änderung des Überwachungssignals z. B. ein Erfassen einer Impulsantwort sein. Insgesamt können dadurch auf vorteilhafte Weise eine Mehrzahl unterschiedlicher Schalterstellungen des Wechslerkontakts erkannt bzw. überwacht werden, wodurch eine zuverlässige Diagnose des aktuellen Zustands des Wechslerkontakts ermöglicht wird. Insbesondere unter dem Aspekt der funktionalen Sicherheit (z.B. nach der Norm IEC 61508) kann so ein eindeutiges Erfassen des Kontaktzustands des Wechslerkontakts realisiert werden und entsprechend ein hoher Diagnosedeckungsgrad erreicht werden.

Nach einem ersten Aspekt der Erfindung kann die Sensierschaltung ausgebildet sein, eine Amplitude, eine Frequenz, eine Phasenlage, ein Abklingverhalten, eine Laufzeit und/oder eine Signalform des Überwachungssignals in Abhängigkeit der Schalterstellung des Wechslerkontakts zu verändern. Zudem oder alternativ kann die die Sensierschaltung auch ausgebildet sein, eine Amplitude, eine Frequenz, eine Phasenlage, ein Abklingverhalten, eine Laufzeit und/oder eine Signalform des vom Überwachungssignal abgeleitete Signals in Abhängigkeit der Schalterstellung des Wechslerkontakts zu verändern. Beispielsweise kann die Sensierschaltung ausgebildet sein, ausgehend von einer ersten Schalterstellung (Grundstellung) die Amplitude des Überwachungssignals zu erhöhen, falls der Wechslerkontakt in eine zweite Schalterstellung überführt wird, und im Vergleich zur Amplitude in der ersten Schalterstellung zu erniedrigen, falls der Wechslerkontakt in eine dritte Schalterstellung überführt wird. Das Überwachungssignal kann dabei ein kontinuierliches Überwachungssignal oder ein impulsartiges Überwachungssignal sein. Grundsätzlich kann die Sensierschaltung dabei so ausgelegt sein, jeweils dieselbe(n) Kenngröße(n) des Überwachungssignals und/oder des vom Überwachungssignal abgeleiteten Signals als Funktion der Schalterstellung zu verändern (z. B. immer die Frequenz). Alternativ kann die Sensierschaltung jedoch auch so ausgelegt sein, in Abhängigkeit der Schalterstellung jeweils zumindest teilweise verschiedene Kenngrößen des Überwachungssignals und/oder des vom Überwachungssignal abgeleiteten Signals zu verändern (z. B. in einer ersten Schalterstellung die Frequenz und in einer zweiten Schalterstellung die Amplitude). Das Verändern bzw. Beeinflussen der vorgenannten Kenngrößen des Überwachungssignals und/oder des vom Überwachungssignal abgeleiteten Signals kann dabei z. B. durch ein Einkoppeln, das Schwingungsverhalten des Signalgenerators beeinflussender, Größen (wie z. B. eine Impedanz) in den Signalgenerator in Abhängigkeit der Schalterstellung erfolgen.

Gemäß einem weiteren Aspekt der Erfindung kann der Wechslerkontakt einen, vorzugsweise gemeinsamen, COM-Anschluss, einen NC Anschluss und einen NO-Anschluss umfassen. Ferner kann die Sensierschaltung ausgebildet sein, das Überwachungssignal und/oder das vom Überwachungssignal abgeleitete Signal für zumindest drei, vorzugsweise vier, besonders bevorzugt alle der folgenden Schalterstellungen jeweils unterschiedlich zu verändern. Mit anderen Worten kann die Kontaktüberwachungseinrichtung insgesamt ausgebildet sein, für zumindest drei, vorzugsweise vier, besonders bevorzugt alle der folgenden Schalterstellungen jeweils ein unterschiedliches Überwachungssignal bereitzustellen. Die entsprechenden Schalterstellungen, welche auch als Schaltzustände bezeichnet werden können, sind dabei:
1. keine Verbindung zwischen dem COM- Anschluss, dem NC- Anschluss und dem NO-Anschluss;
2. nur der COM-Anschluss und der NC-Anschluss sind verbunden;
3. nur der COM- Anschluss und der NO-Anschluss sind verbunden;
4. nur der NC-Anschluss und der NO-Anschluss sind verbunden;
5. alle Anschlüsse, d. h. der COM- Anschluss, der NC- Anschluss und der NO-Anschluss sind verbunden.

Der Vorteil davon, dass für möglichst viele der entsprechenden Schalterstellungen jeweils unterschiedliche, d. h. für die jeweilige Schalterstellung charakteristische, Überwachungssignale vom Signalgenerator erzeugt werden können, ist, dass so eine eindeutige Zuordnung der einzelnen Schaltzustände erfolgen kann, wodurch auf vorteilhafte Weise eine möglichst genaue Diagnose des Wechslerkontakts ermöglicht wird.

Erfindungsgemäß umfasst die Sensierschaltung eine oder mehrere Impedanzen.

Ferner ist die Sensierschaltung ausgebildet, mit dem Wechslerkontakt eine, mit der Schalterstellungen des Wechslerkontakts variierende, Gesamtimpedanz an der Koppeleinrichtung bereitzustellen. Mit anderen Worten ist die Sensierschaltung ausgebildet**,** in Abhängigkeit der Schalterstellungen des Wechslerkontakts die an der Koppeleinrichtung anliegende Gesamtimpedanz zu verändern. Diese veränderte Gesamtimpedanz kann sodann im Signalgenerator bzw. in der Oszillatorschaltung in einer Veränderung des dort erzeugten Überwachungssignals resultieren. Beispielsweise kann eine Vergrößerung der Gesamtimpedanz eine Verkleinerung der Amplitude des Überwachungssignals bewirken.

Zudem oder alternativ kann die Sensierschaltung auch ausgebildet sein, für zumindest drei, vorzugsweise vier, besonders bevorzugt fünf Schalterstellungen des Wechslerkontakts jeweils eine unterschiedliche Gesamtimpedanz an der Koppeleinrichtung bereitzustellen. Beispielsweise kann für eine erste Schalterstellung eine erste Gesamtimpedanz bereitgestellt werden, für eine zweite Schalterstellung eine zweite Gesamtimpedanz bereitgestellt werden, etc. Mit anderen Worten kann die Sensierschaltung ausgebildet sein, mit dem Wechslerkontakt für zumindest drei, vorzugsweise vier, besonders bevorzugt fünf Schalterstellungen jeweils eine charakteristische Gesamtimpedanz an der Koppeleinrichtung einzustellen, welche sodann über die Koppeleinrichtung in den Signalgenerator zur Veränderung der dortigen Überwachungssignalerzeugung eingekoppelt wird. Auf vorteilhafte Weise kann so insgesamt eine einfache Möglichkeit zur Variation des Schwingungssignals als Funktion der Schalterstellung bereitgestellt werden, welche sodann eine zuverlässige Überwachung des Wechslerkontakts ermöglicht.

Nach einem weiteren Aspekt der Erfindung kann die Sensierschaltung eine erste Impedanz umfassen, die mit einem Anschluss des Wechslerkontakts, vorzugsweise dem COM Anschluss, koppelbar oder gekoppelt ist. Vorzugsweise ist die erste Impedanz dabei in Form einer Reihenschaltung aus einem Widerstand und einer Kapazität ausgebildet, wobei der Widerstand bzw. die Kapazität zur besseren Unterscheidbarkeit im Folgenden als "erster" Widerstand und "erste" Kapazität bezeichnet werden sollen.

Zudem oder alternativ kann die Sensierschaltung auch eine zweite Impedanz umfassen, die mit einem weiteren Anschluss des Wechslerkontakts, vorzugsweise dem NC-Anschluss, koppelbar oder gekoppelt ist. Bevorzugt ist dabei auch diese zweite Impedanz in Form einer Reihenschaltung aus einem "zweiten" Widerstand und einer "zweiten" Kapazität ausgebildet. Zudem oder alternativ kann die Sensierschaltung auch eine dritte Impedanz umfassen, die mit einem weiteren Anschluss des Wechslerkontakts, vorzugsweise dem NO-Anschluss, koppelbar oder gekoppelt ist. Vorzugsweise ist auch diese in Form einer Reihenschaltung aus einem "dritten" Widerstand und einer "dritten" Kapazität ausgebildet. Auf vorteilhafte Weise kann so eine entsprechende Verschaltung von Impedanzen bereitgestellt werden, welche es ermöglicht, die an der Koppeleinrichtung anliegende Gesamtimpedanz und damit die Überwachungssignalerzeugung in Abhängigkeit der Schalterstellungen des Wechslerkontakts zu variieren, wodurch auf einfache Weise eine Überwachung bzw. Bestimmung des Wechslerkontaktzustands ermöglicht wird.

Gemäß einem weiteren Aspekt der Erfindung kann die Sensierschaltung eine bis drei weitere Impedanzen umfassen, welche im Folgenden zur besseren Unterscheidung als vierte, fünfte und sechste Impedanz bezeichnet werden sollen. Die jeweilige Impedanz kann dabei jeweils einem Anschluss des Wechslerkontakts nachgeschaltet sein. Beispielsweise kann die vierte Impedanz dem COM-Anschluss nachgeschaltet sein, die fünfte Impedanz dem NC-Anschluss nachgeschaltet sein und/oder die sechste Impedanz dem NO-Anschluss nachgeschaltet sein. Die entsprechenden Impedanzen, welche z. B. eine Induktivität oder ein Ferrit umfassen können, können hierbei dazu dienen, hochfrequente Signale zu dämpfen, welche mittels der Koppeleinrichtung am Wechslerkontakt und/oder an einer an den Wechslerkontakt gekoppelten elektrischen Last und/oder Spannungsquelle anliegen. Mit anderen Worten können die vierte, fünfte und/oder sechste Impedanz als Filterelemente fungieren, wobei anstelle von Impedanzen auch andere dem Fachmann bekannte Möglichkeiten der Filterung eingesetzt werden können. Vorzugsweise sind die Impedanzen bzw. die Filterelemente dabei in einem Frequenzbereich von 100 kHz bis 100 MHz hochohmig, sodass das Überwachungssignal nicht bzw. nur mit verringerter Signalamplitude ggf. an den Wechslerkontakt angeschlossenen Lasten anliegt. Auf vorteilhafte Weise kann so eine zuverlässige Überwachung des Wechslerkontakts erreicht werden, welche für entsprechende Nutzsignale quasi keine Beeinträchtigung darstellt. Mit anderen Worten ist die Kontaktüberwachungseinrichtung für typische DC oder niederfrequente Nutzsignale "von außen betrachtet" auf vorteilhafte Weise nicht bzw. kaum bemerkbar.

Nach einem weiteren Aspekt der Erfindung kann die Sensierschaltung zumindest eine weitere Impedanz umfassen, wobei die zumindest eine weitere Impedanz jeweils zwischen zwei Anschlüssen des Wechslerkontakts geschaltet ist. Bevorzugt umfasst die Sensierschaltung dabei ein, zwei oder drei weitere Impedanzen, welche im Folgenden zur besseren Unterscheidbarkeit als siebte, achte und neunte Impedanz bezeichnet werden sollen. Beispielsweise kann die siebte bezeichnet werden sollen. Ebenso kann auch die achte Impedanz vorzugsweise in Form einer Reihenschaltung aus einer achten Induktivität und einer achten Kapazität ausgebildet sein. Letztlich kann auch die neunte Impedanz vorzugsweise in Form einer Reihenschaltung aus einer neunten Induktivität und einer neunten Kapazität ausgebildet sein. Die entsprechenden Impedanzen können hierbei dazu dienen, hochfrequente Signale zwischen den Anschlüssen des Wechslerkontakts zu dämpfen. Vorzugsweise weisen die vorgenannten LC-Serienschwingkreise dabei eine Serienresonanzfrequenz auf, die im Bereich der Frequenz des Überwachungssignals liegt. Die Impedanz der Serienschwingkreise ist damit bei der Serien-Resonanzfrequenz lediglich durch resistive Anteile der Induktivität und der Kapazität gegeben und damit sehr gering. Auf vorteilhafte Weise kann dadurch erreicht werden, dass einerseits Spannungssignale zwischen den Anschlüssen und damit elektromagnetische Störaussendungen reduziert werden und andererseits die Beeinflussung der Sensierschaltung durch ggf. angeschlossene Lasten bei der Betriebsfrequenz des Signalgenerators minimiert wird, da diese parallel zu der geringen siebten bzw. achten Impedanz geschaltet sind.

Gemäß einem weiteren Aspekt der Erfindung kann der Wechslerkontakt ein Wechslerkontakt eines Relais sein. In diesem Zusammenhang kann der Wechslerkontakt auch als Relais-Wechslerkontakt bezeichnet werden. Das Relais kann dabei z. B. ein elektromechanisches Relais sein, bei dem der Wechslerkontakt mittels einer Relaisspule und eines beweglichen Relaisankers schaltbar ist. Alternativ kann das Relais jedoch auch ein Halbleiterrelais sein. Zudem oder alternativ kann Kontaktüberwachungseinrichtung auch Teil eines Relais-Sockels sein. Mit anderen Worten kann die Kontaktüberwachungseinrichtung in einen Relais-Sockel integriert sein. Vorzugsweise wird die Kontaktüberwachungseinrichtung dabei von einem Relaissockelgehäuse umhaust.

Nach einem weiteren Aspekt der Erfindung kann die Koppeleinrichtung (a) ein induktiver Übertrager sein. Beispielsweise kann die Koppeleinrichtung (b) einen Transformator umfassen, welcher eine erste Induktivität (z. B eine erste Luftspule) und eine zweite Induktivität (z. B eine zweite Luftspule) aufweisen kann, wobei die erste Induktivität mit der zweiten Induktivität (z. B. über einen Ferrit- oder Magnetkern) induktiv gekoppelt sein kann. Der Vorteil einer entsprechenden Ausführung mit Luftspulen ist dabei, dass die Spulen mittels Leiterplattentechnologie herstellbar sein können und entsprechend bei einer Herstellung der Kontaktüberwachungsvorrichtung eine Anzahl von diskreten elektronischen Bauteilen reduziert werden kann. Zudem oder alternativ kann die Koppeleinrichtung (c) ausgebildet sein, den Signalgenerator und die Sensierschaltung galvanisch zu trennen. Alternativ kann die Koppeleinrichtung jedoch auch als eine direkte galvanische Anbindung der Sensierschaltung an den Signalgenerator (z. B. in Form einer Kabel- bzw. Leiterverbindung) ausgebildet sein. Zudem oder alternativ kann die Koppeleinrichtung auch aus (d) mindestens zwei elektromagnetisch gekoppelten Antennen ausgebildet sein. Zudem oder alternativ kann die Koppeleinrichtung auch aus (e) mindestens zwei Kapazitäten ausgebildet sein. Vorzugsweise sind die zwei Kapazitäten dabei als Leiterplattenkondensatoren ausgeführt.

Optional sind die Merkmale (a), (b) und (c) oder die Merkmale (a), (c) und (d) oder die Merkmale (c) und (e) paarweise oder vollständig miteinander kombinierbar.

Gemäß einem weiteren Aspekt der Erfindung kann der Signalgenerator ein Hochfrequenzgenerator sein, der ausgebildet ist, ein hochfrequentes Überwachungssignal zu erzeugen. Beispielsweise kann das Überwachungssignal eine Frequenz von mindestens 10 kHz, vorzugsweise von mindestens 100 kHz, oder weiter vorzugsweise von mindestens 1 MHz aufweisen. Dadurch kann insbesondere der Vorteil erreicht werden, dass eine Frequenztrennung des Überwachungssignals und des vom Wechslerkontakt geschalteten Nutzsignals durch kostengünstige Frequenzfilterelemente realisiert werden kann. Zudem oder alternativ kann der Signalgenerator auch eine Colpitts-Oszillatorschaltung umfassen. Zudem oder alternativ kann der Signalgenerator über die Koppeleinrichtung und die Sensierschaltung, beispielsweise parallel, an den Wechslerkontakt angeschaltet sein.

Nach einem weiteren Aspekt der Erfindung kann der Signalgenerator einen Abgriff (z. B. einen Spannungsabgriff) aufweisen. Ferner kann der Signalgenerator ausgebildet sein, über den Abgriff der Auswerteeinrichtung das Überwachungssignal und/oder ein vom Überwachungssignal abgeleitetes Signal bereitzustellen. Anders ausgedrückt kann die Auswerteeinrichtung über den Abgriff mit dem Signalgenerator verbunden sein. Auf vorteilhafte Weise kann so eine einfache Anbindung der Auswerteeinrichtung an den Signalgenerator realisiert werden.

Gemäß einem weiteren Aspekt der Erfindung kann das Überwachungssignal zumindest ein erstes Überwachungsteilsignal und ein zweites Überwachungsteilsignal umfassen. Beispielsweise kann das erste Überwachungsteilsignal eine vom zweiten Überwachungsteilsignal unterschiedliche Frequenz und/oder eine unterschiedliche Signalform aufweisen und/oder zu einem unterschiedlichen Zeitpunkt generiert werden. Mit anderen Worten können das erste Überwachungsteilsignal und das zweite Überwachungsteilsignal unterschiedlich bzw. unterscheidbar sein, wobei grundsätzlich auch mehr als zwei unterschiedliche bzw. unterscheidbare Überwachungsteilsignal (z. B. drei Überwachungsteilsignale) verwendet werden können. In diesem Zusammenhang soll als "Überwachungssignal" das aus allen Überwachungsteilsignalen zusammengesetzte bzw. aus diesen Bestandteilen bestehende Signal verstanden werden. Weiterhin kann hierbei vorgesehen sein, dass mittels der Sensierschaltung das erste Überwachungsteilsignal und/oder ein vom ersten Überwachungsteilsignal abgeleitetes Signal in Abhängigkeit einer Schaltstellung einer ersten Anschlussteilmenge des Wechslerkontakts und das zweite Überwachungsteilsignal und/oder ein vom zweiten unterscheidbare Überwachungsteilsignal (z. B. drei Überwachungsteilsignale) verwendet werden können. In diesem Zusammenhang soll als "Überwachungssignal" das aus allen Überwachungsteilsignalen zusammengesetzte bzw. aus diesen Bestandteilen bestehende Signal verstanden werden. Weiterhin kann hierbei vorgesehen sein, dass mittels der Sensierschaltung das erste Überwachungsteilsignal und/oder ein vom ersten Überwachungsteilsignal abgeleitetes Signal in Abhängigkeit einer Schaltstellung einer ersten Anschlussteilmenge des Wechslerkontakts und das zweite Überwachungsteilsignal und/oder ein vom zweiten Überwachungsteilsignal abgeleitetes Signal in Abhängigkeit einer Schaltstellung einer zweiten Anschlussteilmenge des Wechslerkontakts veränderbar ist. Vorzugsweise ist die erste Anschlussteilmenge dabei zumindest teilweise unterschiedlich von der zweiten Anschlussteilmenge. Beispielsweise kann das erste Überwachungsteilsignal und/oder das vom ersten Überwachungsteilsignal abgeleitete Signal in Abhängigkeit des Schaltzustands vom COM- und NO-Anschluss veränderbar sein, während das zweite Überwachungsteilsignal und/oder das vom zweiten Überwachungsteilsignal abgeleitetes Signal in Abhängigkeit des Schaltzustands vom COM- und NC-Anschluss veränderbar sein kann. D. h. mit anderen Worten können die jeweiligen Überwachungsteilsignale und/oder die von den Überwachungsteilsignalen abgeleiteten Signale jeweils nur einem Teil der Anschlüsse des Wechslerkontakts zugeordnet sein bzw. nur auf eine Änderung eines Teils der Anschlüsse des Wechslerkontakts reagieren.

Nach einem weiteren Aspekt der Erfindung kann der Signalgenerator eine erste Signalgeneratoreinrichtung zur Erzeugung des ersten Überwachungsteilsignals und eine zweite Signalgeneratoreinrichtung zur Erzeugung des zweiten Überwachungsteilsignals umfassen. Beispielsweise kann die erste Signalgeneratoreinrichtung ein erster Hochfrequenzgenerator sein, der ausgebildet ist, ein hochfrequentes erstes Überwachungssignal zu erzeugen und die zweite Signalgeneratoreinrichtung ein zweiter Hochfrequenzgenerator sein, der ausgebildet ist, ein hochfrequentes zweites Überwachungssignal zu erzeugen. Zudem oder alternativ kann die Koppeleinrichtung auch ein erstes Koppelelement (z. B. einen ersten Transformator) zur Kopplung der ersten Signalgeneratoreinrichtung an die Sensierschaltung und ein zweites Koppelelement (z. B. einen zweiten Transformator) zur Kopplung der zweiten Signalgeneratoreinrichtung an die Sensierschaltung umfassen. Beispielsweise kann das erste Koppelelement ein erster Transformator und das zweite Koppelelement ein zweiter Transformator sein, wobei grundsätzlich auch andere vorstehend beschriebene Arten der Kopplung (z. B. kapazitiv oder in Form einer Leiterverbindung) verwendet werden können. Zudem oder alternativ kann die Sensierschaltung auch ausgebildet sein, das erste Überwachungsteilsignal an eine erste Anschlussteilmenge des Wechslerkontakt zu koppeln und das zweite Überwachungsteilsignal an eine zweite Anschlussteilmenge zu koppeln. Mit anderen Worten kann die Sensierschaltung ausgebildet sein, die entsprechenden Überwachungsteilsignale jeweils nur an bestimmte Anschlüsse des Wechslerkontakt zu koppeln.

Gemäß einem weiteren Aspekt der Erfindung kann die Auswerteeinrichtung ausgebildet sein, in Abhängigkeit des Überwachungssignals und/oder der Änderung des Überwachungssignals ein Zustandssignal auszugeben, welches die Schalterstellungen des Wechslerkontakts anzeigt. Zudem oder alternativ kann die Auswerteeinrichtung auch ausgebildet sein, in Abhängigkeit eines vom Überwachungssignal abgeleiteten Signals und/oder der Änderung des vom Überwachungssignal abgeleiteten Signals ein Zustandssignal auszugeben, welches die Schalterstellungen des Wechslerkontakts anzeigt. Beispielsweise kann die Auswerteeinrichtung ausgebildet sein, ein Zustandssignal bereitzustellen, welches proportional zur aktuellen Amplitude, Frequenz, Phasenlage und/oder Signalform des Überwachungssignals und/oder des vom Überwachungssignal abgeleiteten Signals ist. Vorzugsweise umfasst das Zustandssignal dabei zumindest drei, vorzugsweise vier, besonders bevorzugt fünf, verschiedene Signalzustände. D. h. mit anderen Worten kann das Zustandssignal den Ist Schaltzustand des Wechslerkontakts charakterisieren. Ferner kann die Auswerteeinrichtung ausgebildet sein, das vorgenannte Zustandssignal sodann mit einem, z. B. von einem von der Ansteuerung des Wechslerkontakts generierten Schaltsignal abgeleiteten, Soll Schaltzustandssignal zu vergleichen, um dadurch einen ordnungsgemäßen Schaltvorgang bzw. den Zustand des Wechslerkontakts zu überwachen.

Nach einem weiteren Aspekt der Erfindung kann die Auswerteeinrichtung ausgebildet sein, ein (z. B. von einer Ansteuerung des Wechslerkontakts generiertes) Schaltsignal zum Schalten des Wechslerkontakts zu erfassen. Dazu kann die Auswerteeinrichtung mit der entsprechenden Ansteuerung z. B. über einen Schaltsteueranschluss verbunden sein. Ferner kann die Auswerteeinrichtung ausgebildet sein, in Abhängigkeit des Schaltsignals sowie des Überwachungssignals und/oder der Änderung des Überwachungssignals ein Kontrollsignal auszugeben, welches anzeigt, ob der Wechslerkontakt entsprechend dem Schaltsignal geschaltet ist. Zudem oder alternativ kann die Auswerteeinrichtung auch ausgebildet sein, in Abhängigkeit des Schaltsignals sowie eines vom Überwachungssignal abhängigen Signals und/oder der Änderung des vom Überwachungssignal abhängigen Signals ein Kontrollsignal auszugeben, welches anzeigt, ob der Wechslerkontakt entsprechend dem Schaltsignal geschaltet ist. Leidglich beispielhaft kann das Kontrollsignal ein binäres Signal mit einem ersten Signalwert und einem zweiten Signalwert sein, wobei der erste Signalwert einen korrekten Schaltvorgang und der zweite Signalwert einen fehlerhaften Schaltvorgang anzeigt.

Gemäß einem weiteren Aspekt der Erfindung kann die Auswerteeinrichtung ferner ausgebildet sein, mit dem Empfangen des Schaltsignals das Überwachungssignal und/oder die Änderung des Überwachungssignals innerhalb eines vorbestimmten Zeitintervalls zu erfassen, um festzustellen, ob der Wechslerkontakt innerhalb des vorbestimmten Zeitintervalls entsprechend dem Schaltsignal geschaltet ist. Zudem oder alternativ kann die Auswerteeinrichtung auch ausgebildet sein, mit dem Empfangen des Schaltsignals das vom Überwachungssignal abgeleitete Signal und/oder die Änderung des Überwachungssignals und/oder des vom Überwachungssignal abgeleiteten Signals innerhalb eines vorbestimmten Zeitintervalls zu erfassen, um festzustellen, ob der Wechslerkontakt innerhalb des vorbestimmten Zeitintervalls entsprechend dem Schaltsignal geschaltet ist. Das vorbestimmte, d. h. zuvor festgelegte, Zeitintervall kann z. B. 50 ms sein. Auf vorteilhafte Weise kann dadurch insgesamt eine bedarfsgerechte Überwachung des Wechslerkontakts realisiert werden. In einer Ausführungsform kann die Kontaktüberwachungsvorrichtung dabei ein optisches Anzeigeelement umfassen, welches ausgebildet ist, das Erfassen des Schaltsignals und ein entsprechendes erfasstes Schalten des Wechslerkontakts respektive eine Abweichung von dem erwarteten Schaltsignals anzuzeigen.

Nach einem weiteren Aspekt der Erfindung kann die Kontaktüberwachungseinrichtung eine Ansteuerung zur Steuerung des Schaltzustands des Wechslerkontakts umfassen. Mit anderen Worten kann über die Ansteuerung der Schaltzustand des Wechslerkontakts vorgegeben werden. Dazu kann die Ansteuerung ausgebildet sein, ein entsprechendes Schaltsignal an den Wechslerkontakt auszugeben (z. B. zur Bestromung einer dem Wechslerkontakt zugeordneten Relaisspule). Vorzugsweise ist die Ansteuerung zusätzlich auch mit der Auswerteeinrichtung signaltechnisch verbunden, um dieser das Schaltsignal und/oder ein von diesem abgeleitetes Soll-Schaltzustandssignal bereitzustellen.

Gemäß einem weiteren Aspekt der Erfindung kann die Kontaktüberwachungseinrichtung und der Wechslerkontakt von einem gemeinsamen Gehäuse umhaust werden. Mit anderen Worten können die Kontaktüberwachungseinrichtung und der Wechslerkontakt eine bauliche Einheit bilden. Vorzugsweise umfasst das Gehäuse dabei eine Mehrzahl von Anschlüssen, welche z. B. in Form von Buchsensteckern ausgebildet sein können. Beispielsweise kann das Gehäuse einen Versorgungsanschluss 11d zur Energieversorgung der Kontaktüberwachungseinrichtung, zwei Steueranschlüsse zur Steuerung des Schaltzustands des Wechslerkontakts, drei Lastanschlüsse zur Verbindung mit einer zu schaltenden Last und/oder einen Ausgangsanschluss zur Ausgabe eines Zustands- und/oder Kontrollsignals umfassen. Insgesamt kann so auf vorteilhafte Weise eine baulich kompakte integrierte Lösung zur Überwachung eines Wechslerkontakts bereitgestellt werden. Alternativ dazu kann die Kontaktüberwachungseinrichtung allerdings auch eine vom Wechslerkontakt separate Vorrichtung sein. Beispielsweise kann die Kontaktüberwachungseinrichtung Teil eines Modulsockels sein, in welchen ein entsprechendes Schaltmodul mit einem Wechslerkontakt eingesteckt werden kann. In diesem Fall kann die Kontaktüberwachungseinrichtung bzw. der Modulsockel ferner drei Kontaktanschlüsse umfassen, welche z. B. als Buchsenstecker ausgeführt sein können, und zur Aufnahme korrespondierender Kontakte am Wechslerkontakt bzw. Schaltmodul ausgebildet sind. Weiterhin kann die Kontaktüberwachungseinrichtung bzw. der Modulsockel ein oder mehrere Schaltsignalausgänge zur Bereitstellung eines Schaltsignals für den Wechslerkontakt umfassen, wobei Schaltsignalausgänge wiederum zur Aufnahme korrespondierender Schaltkontakte am Wechslerkontakt bzw. Schaltmodul ausgebildet sein können.

Die zuvor beschriebenen Aspekte und Merkmale der Erfindung sind dabei beliebig miteinander kombinierbar. Weitere Einzelheiten und Vorteile der Erfindung werden im Folgenden unter Bezugnahme auf die beigefügten Zeichnungen beschrieben. Es zeigen:
- Figur 1:: eine schematische Darstellung eines dreipoligen Wechslerkontakts gemäß einer allgemeinen Ausführungsform;
- Figur 2:: eine schematische Darstellung einer Kontaktüberwachungseinrichtung für einen dreipoligen Wechslerkontakt gemäß einer Ausführungsform der Erfindung;
- Figur 3:: eine schematische Darstellung einer Kontaktüberwachungseinrichtung für einen dreipoligen Wechslerkontakt gemäß einer weiteren Ausführungsform der Erfindung;
- Figur 4:: eine tabellarische Auflistung ausgewählter Zustände des Wechslerkontakts und die hieraus resultierende Verschaltung der Impedanzen für die in Figur 3 gezeigte Ausführungsform;
- Figur 5:: eine tabellarische Auflistung ausgewählter Zustände des Wechslerkontakts und die hieraus resultierende Verschaltung der Impedanzen für eine Weiterbildung der in Figur 4 beschriebenen Ausführungsform;
- Figur 6:: frequenzabhängige Verläufe des Betrags der Impedanz an der Signalgeneratorseite der Koppeleinrichtung einer Kontaktüberwachungseinrichtung in einer Ausführungsform für unterschiedliche Zustände des Wechslerkontakts;
- Figur 7:: eine schematische Darstellung einer Kontaktüberwachungseinrichtung für einen dreipoligen Wechslerkontakt gemäß einer weiteren Ausführungsform der Erfindung; und
- Figur 8:: eine tabellarische Auflistung ausgewählter Zustände des Wechslerkontakts und die hieraus resultierenden Überwachungssignale für die in Figur 7 gezeigte Ausführungsform.

Gleiche oder funktional äquivalente Elemente sind in allen Figuren mit denselben Bezugszeichen beschrieben und zum Teil nicht gesondert beschrieben.

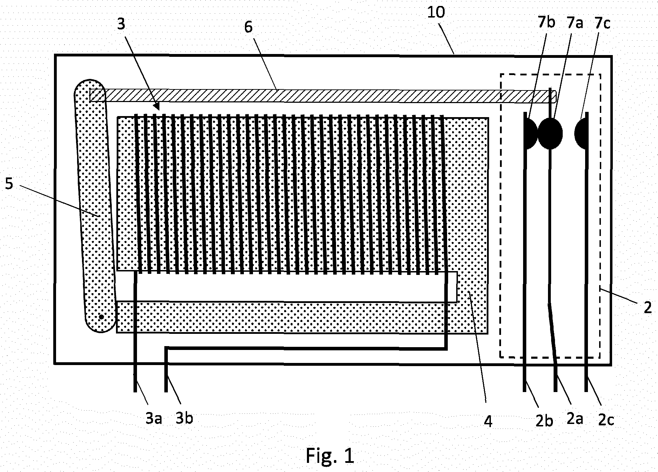

Figur 1 zeigt eine schematische Darstellung eines dreipoligen Wechslerkontakts 2 gemäß einer allgemeinen Ausführungsform. Vorliegend ist der Wechslerkontakt 2 dabei - lediglich beispielhaft - ein Teil eines elektromechanischen Relais 10 bzw. Wechslerrelais. Das Relais 10 umfasst dabei drei, dem Wechslerkontakts 2 zugeordnete, Anschlüsse, welche im Folgenden - gemäß der üblichen Konvention - als COM-Anschluss 2a, NC-Anschluss 2b und NO-Anschluss 2c bezeichnet werden sollen. Weiterhin umfasst das Relais 10 zwei Relaisspulenanschlüsse 3a und 3b, über die eine Relaisspule 3 des Relais 10 bestromt werden kann. Über den Stromfluss wird von der Relaisspule 3 ein magnetisches Feld aufgebaut, das in einem magnetischen Kern 4 geführt wird und eine Kraft auf einen beweglichen Relaisanker 5 ausübt, der wiederum über einen Schieber 6 eine Bewegung ein oder mehrerer, den jeweiligen Anschlüssen 2a, 2b, 2c zugeordneter Kontaktelemente bzw. Kontaktpillen 7a, 7b, 7c verursacht. Beispielsweise wird im vorliegenden - lediglich exemplarischen - Fall bei Stromfluss durch die Spule 3 die COM Kontaktpille 7a mit der NO-Kontaktpille 7c verbunden. Wenn der Stromfluss durch die Spule 3 unterbrochen wird, werden die Kontaktpillen 7a, 7b, 7c, z. B. aufgrund einer entsprechenden federnden Verspannung des COM-Kontaktelements 7a, wieder in ihre Ursprungslage versetzt werden, d. h. vorliegend die COM-Kontaktpille 7a mit der NC-Kontaktpille 7b kontaktiert. Neben der hier dargestellten Ausführungsform, bei der ein Wechslerkontakt 2 Bestandteil eines elektromechanischen Relais 10 ist, kann der gattungsgemäße Wechslerkontakt 2 jedoch auch in anderen Vorrichtung wie z. B. einem Wechselschalter integriert sein.

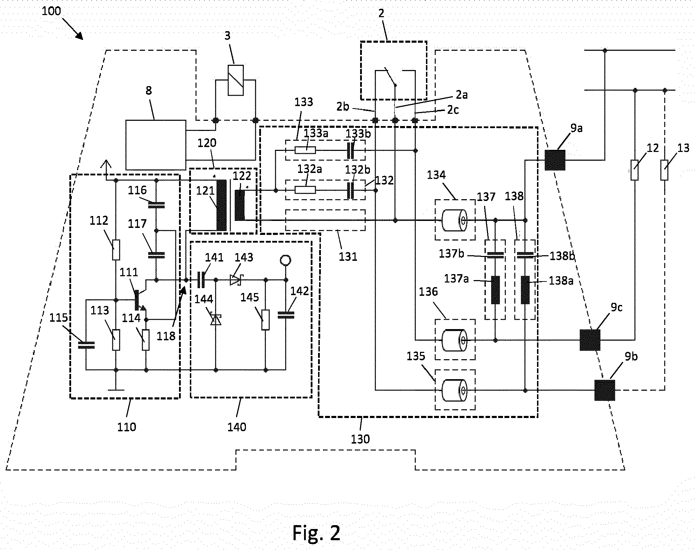

Figur 2 zeigt eine schematische Darstellung einer Kontaktüberwachungseinrichtung 100 für einen dreipoligen Wechslerkontakt 2 gemäß einer Ausführungsform der Erfindung. Als "dreipoliger" Wechslerkontakt 2 soll dabei allgemein ein Wechslerkontakt 2 mit drei Polen bzw. drei Anschlüssen 2a, 2b, 2c verstanden werden. Lediglich beispielhaft kann die Schaltstellung des Wechslerkontakts 2 über eine Ansteuerung 8, welche eine Relaisspule 3 ansteuert, vorgegeben werden, wobei die Relaisspule 3 mit dem Wechslerkontakt 2 bzw. dessen Kontaktelementen, wie vorstehend im Zusammenhang mit Figur 1 beschrieben, zusammenwirken kann. Die Kontaktüberwachungsvorrichtung 100 zur Überwachung des Wechslerkontakts 2 weist einen Signalgenerator 110 auf, welcher ausgebildet ist, ein Überwachungssignal Sü zu erzeugen. Das Überwachungssignal S_{Ü} kann im Allgemeinen eine hochfrequente Hilfsenergie sein. Lediglich beispielshaft kann der Signalgenerator 110 dazu einen Colpitts-Oszillator aufweisen, welcher einen Transistor 111 umfasst, dessen Arbeitspunkt über einen Basisspannungsteiler mit Widerständen 112 und 113 sowie einem Emitterwiderstand 114 eingestellt werden kann. Die Basis des Transistors 111 ist zudem über einen Kondensator 115 mit Masse verbunden, um so an der Basis anliegende Hochfrequenzkomponenten zur Masse kurzzuschließen. Weiterhin umfasst der Colpitts-Oszillator einen, die Frequenz des Überwachungssignals S_{Ü} bestimmenden, Schwingkreis aus zwei in Reihe geschalten Kondensatoren 116 und 117 und einer Induktivität 121, die im vorliegenden Fall als Spule ausgebildet ist und zugleich als Teil einer, im Folgenden noch näher beschriebenen Koppeleinrichtung 120 angesehen werden kann. Über den Kondensator 117 wird ferner ein durch das Kapazitätsverhältnis der Kondensatoren 116 und 117 (kapazitiven Spannungsteiler) bestimmter Spannungsanteil auf den Emitter des Transistors 111 rückgekoppelt, wodurch insgesamt ein Überwachungssignals S_{Ü} in Form eines periodischen Wechselspannungssignals erzeugt werden kann.

Weiterhin umfasst die Kontaktüberwachungseinrichtung 100 eine Koppeleinrichtung 120, welche der Oszillatorschaltung bzw. dem Signalgenerator 110 nachgeschaltet ist. Vorliegend ist die Koppeleinrichtung 120 beispielhaft ein induktiver Übertrager in Form eines Transformators, welcher ausgebildet ist, den Signalgenerator 110 induktiv an eine, im Folgenden noch eingehende beschriebene, Sensierschaltung 130 zu koppeln. Der Transformator weist dazu eine erste Induktivität 121 (z. B. eine erste Planarspule) und eine zweite Induktivität 122 (z. B. eine zweite Planarspule) auf, wobei die erste Induktivität 121 mit der zweiten Induktivität 122, z. B. über einen (nicht dargestellten) Magnetkern, induktiv gekoppelt ist. Wie vorstehend erwähnt, erfüllt die erste Induktivität 121 in der vorliegenden Ausführungsform dabei eine Doppelfunktion, in dem sie einerseits ein Element des Schwingkreises des Oszillators darstellt und andererseits die Anbindung der Koppeleinrichtung 120 an den Signalgenerator 110 bildet. Für eine formal eindeutige Zuordnung der entsprechenden Komponenten kann die erste Induktivität 121 jedoch dem Signalgenerator 110 und die zweite Induktivität 122 bzw. der Magnetkern der Koppeleinrichtung 120 zugeordnet werden. Vorzugsweise erfolgt mittels der Koppeleinrichtung 120 eine galvanische Trennung zwischen dem Signalgenerator 110 und der Sensierschaltung 130.

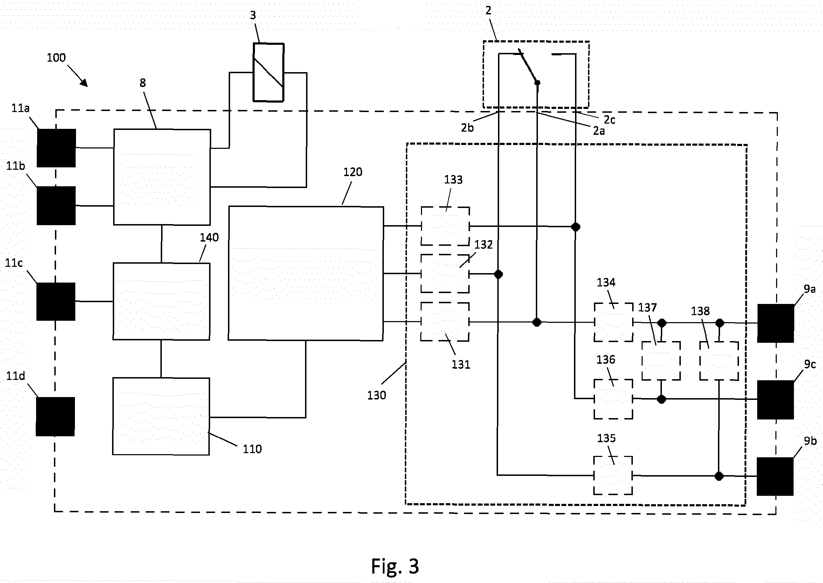

Die Kontaktüberwachungseinrichtung 100 umfasst ferner eine Sensierschaltung 130, welche der Koppeleinrichtung 120 nachgeschaltet ist und an den Wechslerkontakt 2 gekoppelt ist. Mittels vorgenannter, über die Koppeleinrichtung 120 mit dem Signalgenerator 110 gekoppelten, Sensierschaltung 130 kann das Schwingungsverhalten des Signalgenerators 110 und damit das Überwachungssignal S_{Ü} und/oder ein vom Überwachungssignal abgeleitetes Signal (z. B. ein Stromsignal, falls das Überwachungssignal ein Spannungssignal ist) in Abhängigkeit einer Schaltstellung des Wechslerkontakts 2 verändert werden. Insbesondere ist die Sensierschaltung 130 dabei ausgebildet, das vom Signalgenerator 110 erzeugte Überwachungssignal S_{Ü} und/oder des vom Überwachungssignal abgeleitete Signal für zumindest drei, vorzugsweise vier, verschiedene Schalterstellungen des Wechslerkontakts 2 unterschiedlich zu verändern, was im Zusammenhang mit den Figuren 3 bis 6 noch eingehender beschrieben werden wird. Vorliegend umfasst die Sensierschaltung 130 beispielhaft eine Mehrzahl von Impedanzen, weshalb die Sensierschaltung 130 in dieser Ausführungsform auch als Impedanzschaltung bezeichnet werden kann. Zur Veränderung bzw. Beeinflussung des Schwingungsverhalten des Signalgenerators 110 bzw. des von diesem erzeugten Überwachungssignals S_{Ü} umfasst die vorliegende Sensierschaltung 130 dabei im Allgemeinen drei Impedanzen 131, 132 und 133, die jeweils einem der Anschlüsse 2a, 2b bzw. 2c zugeordnet sind. Dabei ist eine erste Impedanz 131 mit dem COM-Anschluss 2a, eine zweite Impedanz 132 mit dem NC-Anschluss 2b und eine dritte Impedanz 133 mit dem NO-Anschluss 2c gekoppelt. Dabei können je nach Auslegung auch ein oder mehrere dieser drei Impedanzen weggelassen werden bzw. Null sein. Lediglich beispielhaft ist in der vorliegenden Ausführung z. B. die erste Impedanz 131 Null bzw. eine einfache direkte elektrisch leitende Verbindung. Die zweite und dritte Impedanz 132 und 133 können ferner z. B. in Form einer Serienschaltung aus einem zweiten bzw. dritten Widerstand 132a, 133a und einem zweiten bzw. dritten Kondensator 132b, 133b realisiert sein.

Die Sensierschaltung 130 kann zudem noch weitere, grundsätzlich jedoch optionale, Impedanzen umfassen, insbesondere falls die Kontaktüberwachungseinrichtung 100 wie in der vorliegenden Ausführung leidglich beispielhaft Teil eines Relaissockels ist, bei dem der COM-, NC- und NO-Anschluss 2a, 2b, 2c an entsprechende Lastanschlüsse 9a, 9b, 9c zur Verbindung mit entsprechenden Lasten (hier z. B. Last 12 bzw. Last 13) elektrisch verbunden ist. So kann z. B. der COM-Anschluss 2a über eine vierte Impedanz 134 mit dem Lastanschluss 9a elektrisch verbunden sein. Der NC-Anschluss 2b kann über eine fünfte Impedanz mit dem Lastanschluss 9b elektrisch verbunden sein und der NO-Anschluss 2c kann über eine sechste Impedanz mit dem Lastanschluss 9c elektrisch verbunden sein. Auch hier können je nach Auslegung wiederum einzelne dieser optionalen Impedanzen auch weggelassen werden, d. h. beispielsweise Null sein bzw. direkte elektrische Verbindungen, z. B. über Leiterbahnen realisiert sein. Vorliegend sind die vierte, fünfte und sechste Impedanz 134, 135, 136 beispielshaft in Form von Ferriten ausgeführt, welche vorzugsweise für niederfrequente Wechselstromsignale niederohmig und für hochfrequente Wechselstromsignale hochohmig sind. Der Vorteil dieser weiteren Impedanzen, d. h. der vierten, fünften und sechsten Impedanz 134, 135, 136, ist dabei, dass durch diese hochfrequenten Signale an den Lastanschlüssen 9a, 9b, 9c aufgrund der Ankopplung an den Signalgenerator 110 gedämpft werden können. Dadurch kann auf vorteilhafte Weise erreicht werden, die Kontaktüberwachungseinrichtung 100 funktional von einer externen Beschaltung an den Lastanschlüsse 9a, 9b, 9c abzutrennen, während gleichzeitig niederfrequente Signale mit hohen Stromstärken effizient an Anschlüsse 2a, 2b, 2c geleitet werden können. Mit anderen Worten sind von außen betrachtet die Anschlüsse 9a, 9b und 9c aufgrund der niedrigen Impedanzen 134, 135, 136 für ein Nutzsignal quasi identisch mit den jeweiligen Anschlüssen 2a, 2b und 2c, sodass sich ein Relaissockel mit einer Kontaktüberwachungseinrichtung 100 gemäß der gezeigten Ausführungsform nicht bzw. kaum von einem üblichen Standard-Relaissockel unterscheidet.

Zudem oder alternativ können in der Sensier- bzw. Impedanzschaltung 130 auch die optionalen Impedanzen 137 und 138 vorgesehen sein, welche im Folgenden als siebte Impedanz 137 und achte Impedanz 138 bezeichnet werden sollen. Diese Impedanzen 137 und 138 können unterschiedlichen Zwecken z. B. zur Störfestigkeit und Unabhängigkeit von einer äußeren Beschaltung dienen. Lediglich beispielhaft können sie aus Serienschwingkreisen mit einer siebten bzw. achten Induktivität 137a, 138a und einer siebten bzw. achten Kapazität 137b, 138b bestehen, wobei die Serienschwingkreise vorzugsweise jeweils eine Serienresonanzfrequenz bei der Betriebsfrequenz des Signalgenerator 110 aufweisen. Die Impedanz der Serienschwingkreise ist damit bei der Serienresonanzfrequenz lediglich durch resistive Anteile der Induktivität und der Kapazität gegeben und damit sehr gering. Hierdurch kann auf vorteilhafte Weise zum einen ein eingespeistes hochfrequente Spannungssignal zwischen den Anschlüssen 9a und 9b bzw. 9a und 9c reduziert und damit elektromagnetische Störaussendungen an den Anschlussklemmen minimiert werden. Zum anderen kann die Beeinflussung der Sensierschaltung 130 durch mögliche angeschlossene Lasten bei der Betriebsfrequenz des Signalgenerators 110 minimiert werden, da diese parallel zu den geringen Impedanzen 137 und 138 geschaltet sind.

Insgesamt sind bevorzugt möglichst alle in der Sensier- bzw. Impedanzschaltung 130 vorhandenen Impedanzen so dimensioniert, dass sie für das Nutzsignal quasi keine Beeinträchtigung darstellen. Beispielsweise können die Kondensatoren 132b, 133b, 137b und 138b der Impedanzen 132, 133, 137 und 138 sehr klein sein, so dass diese für das Nutzsignal sehr hochimpedant und infolgedessen kaum bzw. nicht merkbar sind. Insofern verhält sich die Sensierschaltung 130 bzw. die Kontaktüberwachungseinrichtung 100 von außen betrachtet für ein (DC oder AC bzw. niederfrequentes) Nutzsignal als nicht bemerkbar gegenüber einer herkömmlichen Schaltung bzw. einfachen Verbindung. Mit anderen Worten sind die Komponenten der Sensierschaltung 130 vorzugsweise so ausgelegt, dass sie die Impedanz zwischen den Anschlüssen 9a, 9b und 9c bei der Betriebsfrequenz der zu schaltenden Lasten (typischerweise Gleichspannung oder 50 Hz bzw. 60 Hz) nicht beeinflussen. Weiterhin sei erwähnt, dass die vorliegend beispielhaft als Lastanschlüsse 9a, 9b, 9c ausgeführten Komponenten nicht notwendigerweise tatsächlich zugängliche Anschlüsse sein müssen. So können die entsprechenden Komponenten auch lediglich Abgriffe für interne Signale eines komplexen Produkts, z. B. eines Produkts mit mehreren Funktionseinheiten, sein, sodass die Anschlüsse 9a, 9b, 9c nur indirekt bzw. als interne Signale/Potentiale vorliegen.

Letztlich umfasst die Kontaktüberwachungseinrichtung 100 auch eine Auswerteeinrichtung 140, welche ausgebildet ist, das Überwachungssignal Sü und/oder das vom Überwachungssignal abgeleitete Signal und/oder eine Änderung des Überwachungssignals S_{Ü} und/oder eine Änderung des vom Überwachungssignal abgeleiteten Signals zu erfassen, um dadurch den Wechslerkontakt 2 zu überwachen. Die Auswerteeinrichtung 140 kann dazu z.B. über einen Abgriff 118 mit dem Signalgenerator 110 verbunden sein, wobei am Abgriff 118 das vom Signalgenerator 110 erzeugte Überwachungssignals S_{Ü} ein vom Überwachungssignal abgeleitetes Signal anliegt. Vorliegend ist die Auswerteeinrichtung 140 - lediglich exemplarisch - in Form einer Greinacher-Schaltung mit zwei Kondensatoren 141 und 142, zwei Dioden 143 und 144 sowie Widerstand 145 ausgeführt, wobei die Schaltung ausgebildet ist, ein gleichgerichtetes Zustandssignal S_{Z} bereitzustellen, welches proportional zur Schwingamplitude von S_{Ü} ist. Das Zustandssignal S_{Z} kann dabei den Ist-Schaltzustand des Wechslerkontakts 2 charakterisieren und anschließend mit z. B. einem, von einem von der Ansteuerung 8 generierten Schaltsignal S_{S} für den Wechslerkontakt 2, abgeleiteten Soll-Schaltzustandssignal verglichen werden, um dadurch einen ordnungsgemäßen Schaltvorgang bzw. den Zustand des Wechslerkontakts 2 zu überwachen.

Figur 3 zeigt eine schematische Darstellung einer Kontaktüberwachungseinrichtung 100 für einen dreipoligen Wechslerkontakt 2 mit drei Anschlüssen 2a, 2b, 2c gemäß einer weiteren Ausführungsform der Erfindung. Grundsätzlich entspricht der Aufbau dabei dem der in Figur 2 dargestellten Ausführungsform, wobei für die nachfolgende Diskussion der Veränderung bzw. Beeinflussung des Überwachungssignals S_{Ü} nur die wesentlichen Komponenten, ohne detaillierte Schaltungen, dargestellt sind. Zusätzlich verfügt die vorliegende Ausführungsform der Kontaktüberwachungseinrichtung 100 über einen Versorgungsanschluss 11d zur Energieversorgung sowie zwei Steueranschlüsse 11a und 11b, welche mit der Ansteuerung 8 zur Ansteuerung der Relaisspule 3 verbunden sind und über welche der Schaltzustand des Wechslerkontakt 2, welcher vorliegend - wieder lediglich beispielhaft - als ein Relais-Wechslerkontakt ausgebildet ist, gesteuert werden kann. Die Auswerteeinrichtung 140 ist sowohl mit der Ansteuerung 8 als auch mit dem Signalgenerator 110 verbunden. Die Auswerteeinrichtung 140 ist ausgebildet, einen von dieser überwachten bzw. ermittelten Ist-Schaltzustand des Wechslerkontakt 2 mit einem von der Ansteuerung 8 vorgegebenen Soll-Schaltzustand zu vergleichen. Über den Ausgangsanschluss 11c kann sodann z. B. ein Kontrollsignal ausgegeben werden, das angibt, ob der vorgegebene Soll-Schaltzustand und der überwachte Ist-Schaltzustand des Wechslerkontakts 2 übereinstimmen.

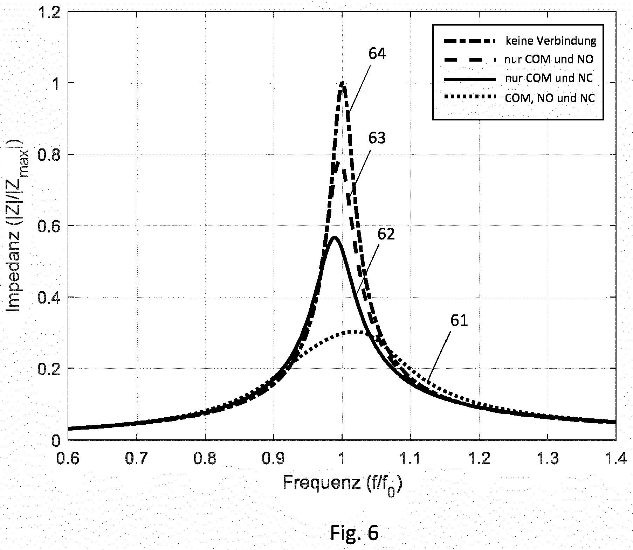

Die Überwachung des Ist-Schaltzustands des Wechslerkontakt 2 erfolgt in der Auswerteeinrichtung 140, wozu das in Abhängigkeit der Schalterstellung des Wechslerkontakts 2 variierende Überwachungssignal S_{Ü} und/oder ein vom Überwachungssignal abgeleitetes Signal erfasst wird. In der vorliegenden Ausführungsform erfolgt das Verändern bzw. Beeinflussen des Überwachungssignal Sü bzw. des vom Überwachungssignal abgeleiteten Signals durch die unterschiedliche Verschaltung der Impedanzen 131-138 der Sensierschaltung 130 in Abhängigkeit der Schalterstellung des Wechslerkontakts 2, sodass je nach Schalterstellung des Wechslerkontakts 2 eine, vorzugsweise unterschiedliche, Gesamtimpedanz über die Koppeleinrichtung 120 in den Signalgenerator 110 eingekoppelt wird, welche wiederum in unterschiedlichen Amplituden des Überwachungssignal S_{Ü} resultiert. Mit anderen Worten können durch geeignete Auslegung der Impedanzen für die typischerweise vier zu unterscheidenden Zustände des Wechslerkontakts 2 bei der Frequenz des Signalgenerators 110 vier unterscheidbare Signalamplituden von Sü generiert werden, welche - wie nachfolgend noch im Zusammenhang mit Figur 6 ausgeführt werden wird - eine eindeutige Zuordnung zwischen Signalamplitude und Ist-Schalterstellung erlauben.

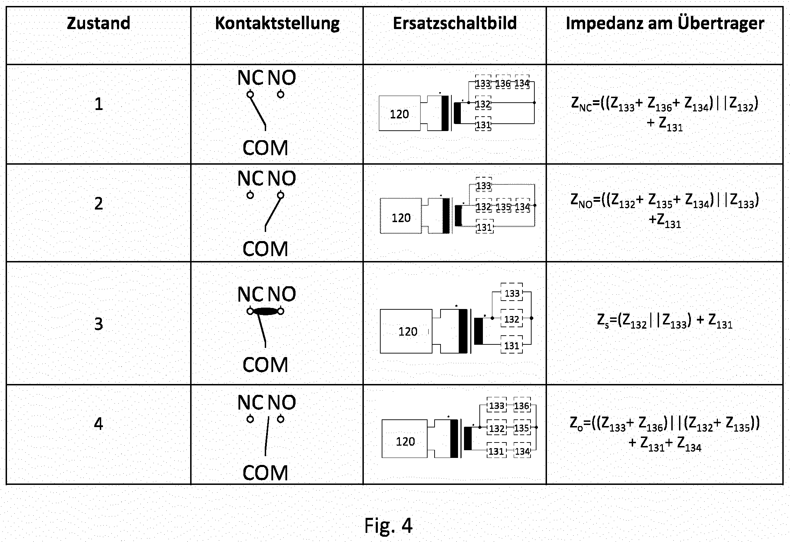

Figur 4 zeigt eine tabellarische Auflistung ausgewählter Zustände des Wechslerkontakts 2 und die hieraus resultierende Verschaltung der Impedanzen 131 bis 138 der Sensierschaltung 130 als Ersatzschaltbild für die vorstehend in Figur 2 bzw. 3 gezeigten Ausführungsformen. Lediglich beispielhaft werden für eine Vereinfachung der Betrachtung hierbei siebte und achte Impedanz 137 und 138 als Null gewählt. Ist der Wechslerkontakt 2 im "Zustand 1", bei dem der COM-Anschluss 2a mit dem NC-Anschluss 2b verbunden ist, wird die erste Impedanz 131 mit der zweiten Impedanz 132 elektrisch verbunden und die Gesamtimpedanz Z_{NC} der entsprechenden Impedanzschaltung ergibt sich aus Z_{NC}= ((Z₁₃₃ + Z₁₃₆ + Z₁₃₄)∥(Z₁₃₂)) + Z₁₃₁, wobei das Symbol | | eine Parallelschaltung und + eine Serienschaltung symbolisiert. Ferner soll der jeweilige Index der Impedanzen Z auf die entsprechend referenzierte Impedanz der Sensierschaltung 130 verweisen. D. h. die Angabe "Z₁₃₃" soll verkürzt die Impedanz 133, bezeichnen, die Angabe "Z₁₃₄" soll verkürzt die Impedanz 134 bezeichnen, etc. Ist der Wechslerkontakt 2 im "Zustand 2", bei dem der COM-Anschluss 2a mit dem NO-Anschluss 2c verbunden ist, ergibt sich eine Gesamtimpedanz Z_{NO} von Z_{NO}= ((Z₁₃₂ + Z₁₃₅ + Z₁₃₄) ∥ Z₁₃₃) + Z₁₃₁. Ist der Wechslerkontakt 2 im "Zustand 3", bei dem der COM-Anschluss 2a mit dem NC-Anschluss 2b verbunden ist, wobei letzterer wiederum mit dem NO-Anschluss 2b verbunden ist, ergibt sich eine Gesamtimpedanz Z_{S} von Z_{S} = (Z₁₃₂ ∥ Z₁₃₃) + Z₁₃₁. Ist der Wechslerkontakt 2 im "Zustand 4", bei dem keinerlei elektrische Verbindung zwischen den drei Anschlüssen 2a, 2b und 2c besteht, ergibt sich eine Gesamtimpedanz Z_{O} von Z_{O}= ((Z₁₃₃ + Z₁₃₆)∥(Z₁₃₂ + Z₁₃₅))+ Z₁₃₁ + Z₁₃₄. Insgesamt können durch entsprechende Auslegung der jeweiligen Impedanzen 131-138 für die einzelnen Schaltzustände des Wechslerkontakts 2 unterschiedliche, d. h. für einen jeweiligen Schaltzustand charakteristische, Gesamtimpedanzen bereitgestellt werden. Diese resultieren sodann im Signalgenerator 110 - vermittelt durch die Kopplung an den Signalgenerator 110 über die Koppeleinrichtung 130 - in der Erzeugung unterschiedlicher, d. h. für einen jeweiligen Schaltzustand charakteristischer, Überwachungssignale S_{Ü}, die sodann von der Auswerteeinrichtung 140 ausgewertet werden können, um Rückschlüsse auf den entsprechenden Schaltzustand des Wechslerkontakt 2 erlauben.

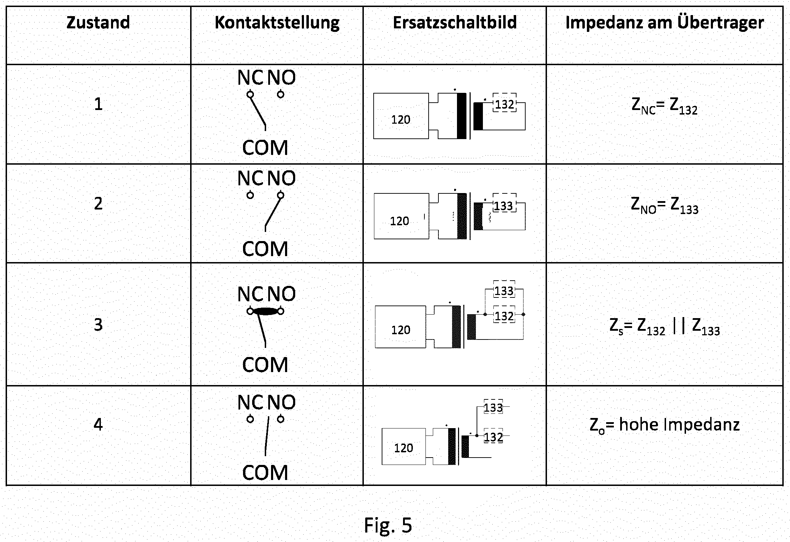

Figur 5 zeigt die tabellarische Auflistung gemäß Figur 4 mit der Weiterbildung, dass die fünfte und sechste Impedanz 135 und 136 als unendlich hoch sowie die erste und vierte Impedanz 131 und 134 als Null gewählt bzw. approximiert werden. Im Schaltzustand 1 des Wechslerkontakts 2 wird die Impedanz 135 überbrückt, sodass sich ein Gesamtimpedanz Z_{NC} = Z₁₃₂ ergibt. Im Schaltzustand 2 wird die Impedanz 136 überbrückt und die Gesamtimpedanz Z_{NO} = Z₁₃₃. Im Schaltzustand 3 werden beide Impedanzen 135 und 136 überbrückt, sodass sich ein Gesamtimpedanz Z_{S} von Z_{S} = Z₁₃₂ ∥ Z₁₃₃ ergibt. Im Schaltzustand 4 des Wechslerkontakts 2 wird keine der beiden Impedanzen 135 und 136 überbrückt und die Gesamtimpedanz Z_{O} ist eine hohe Impedanz. Man erkennt wiederum, dass durch geeignete Dimensionierung der Impedanzen der Sensierschaltung 130 in Abhängigkeit der Schalterstellung unterschiedliche Gesamtimpedanzen bereitgestellt werden können, die entsprechend ausgewertet werden können.

Figur 6 zeigt exemplarische frequenzabhängige Verläufe des Betrags der Impedanz an der Signalgeneratorseite der Koppeleinrichtung 130 einer Kontaktüberwachungseinrichtung 100 in einer Ausführungsform für vier unterschiedliche Zustände des Wechslerkontakts 2. Der entsprechende Wechslerkontakts 2 soll hierbei wiederum einen gemeinsamen COM-Anschluss 2a, einen NC-Anschluss 2b und einen NO Anschluss 2c umfassen. Die Impedanzkurven 61, 62, 63 und 64 - welche im Folgenden zur besseren Unterscheidung als erste, zweite, dritte und vierte Impedanzkurve bezeichnet werden sollen - weisen dabei ein vom Schaltzustand des Wechslerkontakts 2 abhängiges Maximum auf. Die erste Impedanzkurve 61 ist dabei einer Schalterstellung zugeordnet, bei der der COM-, NC- und NO-Anschluss 2a, 2b, 2c, d. h. alle drei Anschlüsse, verbunden sind. Die zweite Impedanzkurve 62 ist einer Schalterstellung zugeordnet, bei der nur der COM-Anschluss 2a und der NC-Anschluss 2b verbunden sind. Die dritte Impedanzkurve 63 ist einer Schalterstellung zugeordnet, bei der nur der COM-Anschluss 2a und der NO-Anschluss 2c verbunden sind. Die vierte Impedanzkurve 64 ist einer Schalterstellung zugeordnet, bei der keinerlei Verbindung zwischen dem COM-, NC- und NO Anschluss 2a, 2b, 2c besteht. Die Kontaktüberwachungsvorrichtung 100 ist durch eine entsprechende Dimensionierung der elektrischen Komponenten, insbesondere durch geeignete Wahl der Impedanzen 132 und 133, ausgebildet, die Impedanzkurven 61, 62, 63 und 64 durch eine möglichst große Amplitudendifferenz zu trennen.

Vorstehend wurde zur Überwachung des Wechslerkontakts vorrangig auf die Beeinflussung bzw. Veränderung der Amplitude des Überwachungssignals in Abhängigkeit einer variierenden Gesamtimpedanz abgestellt. Für den Fachmann ist jedoch sofort ersichtlich, dass auch andere Kenngrößen des Überwachungssignals, z. B. dessen Frequenz, Phasenlage, Abklingverhalten, Laufzeit und/oder Signalform, über eine entsprechende Anpassung der Einheiten der Kontaktüberwachungseinrichtung zur Wechslerkontaktüberwachung genutzt werden können. Wie beispielsweise bereits in Figur 6 ersichtlich ist, liegt das Maximum der Impedanzkurven 61, 62, 63 und 64 nicht exakt bei derselben Frequenz. Neben der Veränderung der Amplitude von S_{Ü} schwingt der Oszillator in der vorliegenden Ausführungsform somit bei den vier Schaltzuständen jeweils bei einer (leicht) unterschiedlichen Frequenz. Durch gezielte Optimierung der Impedanzen 131, 132 und 132 - z. B. durch Verwenden von unterschiedlichen Kapazitäten in den Impedanzen 131, 132 und 133, die im Zusammenspiel mit der bzw. den Induktivitäten 121, 122 der Koppeleinrichtung 120 je nach Kontaktzustand in unterschiedlichen LC-Resonanzfrequenzen resultieren - könnte der Abstand der Resonanzen, d. h. das Maximum der Impedanzkurven 61, 62, 63 und 64, noch weiter vergrößert werden und damit zusätzlich oder alternativ auch eine Unterscheidung der Schalterstellung auf Basis der jeweils charakteristischen Frequenzänderung realisiert werden.

Alternativ ist es auch möglich, dass der Signalgenerator 110 ein impulsartiges Überwachungssignal S_{Ü} generiert, das je nach Zustand des Wechslerkontakts 2 durch die verschiedenen Impedanzen 131 bis 138 unterschiedlich stark beeinflusst wird bzw. beispielsweise unterschiedlich stark gedämpft wird, was wiederum ausgewertet werden kann. Mit anderen Worten kann die Unterscheidung somit auch auf Basis eines für den jeweiligen Schaltzustand charakteristischen Abkling- bzw. Ausschwingverhaltens erfolgen.

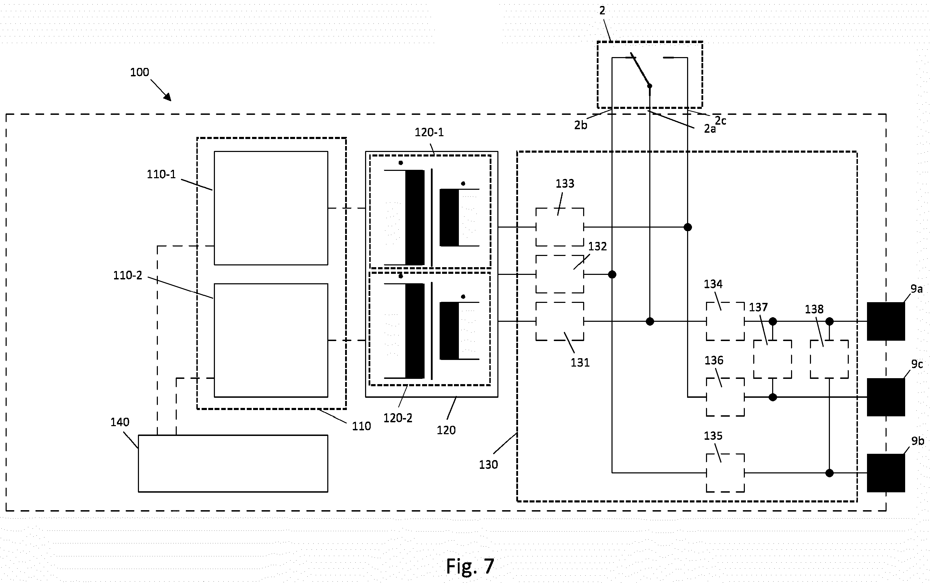

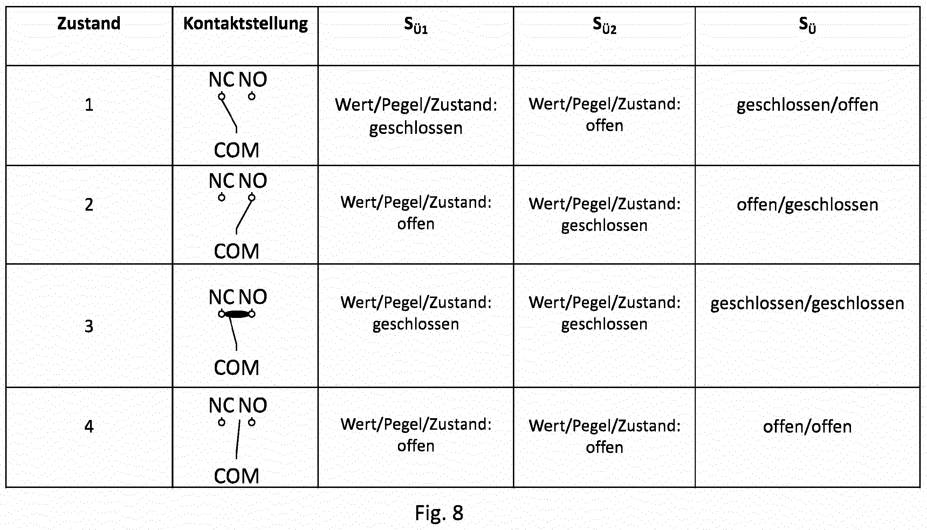

Figur 7 zeigt eine schematische Darstellung einer Kontaktüberwachungseinrichtung 100 für einen dreipoligen Wechslerkontakt 2 mit drei Anschlüssen 2a, 2b und 2c gemäß einer weiteren Ausführungsform der Erfindung. Im Unterschied zu den bisherigen Ausführungsformen weist das Überwachungssignal S_{Ü} vorliegend zumindest ein erstes Überwachungsteilsignal S_{Ü1} und ein zweites Überwachungsteilsignal S_{Ü2} auf. Für deren Erzeugung umfasst der Signalgenerator 110 der Kontaktüberwachungseinrichtung 100 jeweils eine erste Signalgeneratoreinrichtung 110-1 (z. B. ein erster Hochfrequenzgenerator) und eine zweite Signalgeneratoreinrichtung 110-2 (z. B. ein zweiter Hochfrequenzgenerator). Lediglich beispielhaft können das erste Überwachungsteilsignal S_{Ü1} und das zweite Überwachungsteilsignal S_{Ü2} dabei z. B. unterschiedliche Frequenzen enthalten oder zu unterschiedlichen Zeitpunkten generiert werden. Weiterhin umfasst die Koppeleinrichtung 120 in der vorliegenden Ausführungsform ein erstes Koppelelement 120-1 (z. B. einen ersten induktiven Übertrager) zur Kopplung der ersten Signalgeneratoreinrichtung 110-1 an die Sensierschaltung 130 und ein zweites Koppelelement (z. B. einen zweiten induktiven Übertrager) zur Kopplung der zweiten Signalgeneratoreinrichtung 110-2 an die Sensierschaltung 130. Die Sensierschaltung 130 wiederum ist ausgebildet, das erste Überwachungsteilsignal S_{Ü1} an eine erste Anschlussteilmenge des Wechslerkontakt 2 zu koppeln und das zweite Überwachungsteilsignal S_{Ü2} an eine zweite Anschlussteilmenge zu koppeln. Im vorliegenden Fall soll z. B. das erste Überwachungsteilsignal S_{Ü1} an die Anschlüsse 2a und 2b gekoppelt werden und das zweite Überwachungsteilsignal S_{Ü2} an die Anschlüsse 2a und 2c. Mit anderen Worten kann mittels des ersten Überwachungsteilsignal S_{Ü1} der Schaltzustand bezüglich den Anschlüssen 2a und 2b und mittels des zweiten Überwachungsteilsignal S_{Ü2} der Schaltzustand bezüglich den Anschlüssen 2a und 2c überwacht werden. D. h. die jeweiligen Überwachungsteilsignale S_{Ü1} bzw. S_{Ü2} sollen jeweils nur auf eine Änderung eines Teils bzw. einer Teilmenge der drei Anschlüsse 2a, 2b, 2c des Wechslerkontakts 2 reagieren. Insgesamt ist damit mittels der Sensierschaltung 130 das erste Überwachungsteilsignal S_{Ü1} und/oder ein vom erste Überwachungsteilsignal S_{Ü1} abgeleitetes Signal in Abhängigkeit einer Schaltstellung einer ersten Anschlussteilmenge des Wechslerkontakts 2 und das zweite Überwachungsteilsignal S_{Ü2} und/oder ein vom zweiten Überwachungsteilsignal S_{Ü1} abgeleitetes Signal in Abhängigkeit einer Schaltstellung einer zweiten Anschlussteilmenge des Wechslerkontakts 2 veränderbar, was z. B. durch eine entsprechende Dimensionierung der Impedanzen 131-138 der Sensierschaltung 130 erreicht werden kann. Letztlich umfasst die Kontaktüberwachungseinrichtung 100 wiederum eine Auswerteeinrichtung 140, die ausgebildet ist, das erste und zweite Überwachungsteilsignal S_{Ü1} und S_{Ü2} und damit das Überwachungssignal S_{Ü} zu erfassen, um dadurch den Wechslerkontakt 2 zu überwachen. Zudem oder alternativ kann die Auswerteeinrichtung 140 auch ausgebildet sein, ein vom ersten und/oder zweiten Überwachungsteilsignal S_{Ü1} und S_{Ü2} abgeleitetes Signal zu erfassen, um dadurch den Wechslerkontakt 2 zu überwachen. Wie nachfolgend im Zusammenhang mit Figur 8 ausgeführt werden wird, können über eine entsprechende Logik vier verschiedene Schalterstellungen des Wechslerkontaktes 2 rekonstruiert werden.

Figur 8 zeigt eine tabellarische Auflistung ausgewählter Zustände des Wechslerkontakts 2 und die hieraus resultierenden Überwachungssignale S_{Ü1}, S_{Ü2} und S_{Ü} für die in Figur 7 gezeigte Ausführungsform. Vorliegend werden aus den beiden Signalen S_{Ü1} und S_{Ü2} dabei beispielhaft digitale Signale mit den jeweilige Zuständen 1 (geschlossen) und 0 (offen) erzeugt. Dies kann selbstverständlich auch genau andersherum realisiert werden. Über eine geeignete Logik können daraus wie dargestellt die insgesamt 4 Wechslerkontaktzustände rekonstruiert werden.

### Bezugszeichenliste

- 2: Wechslerkontakt
- 2a: COM-Anschluss
- 2b: NC-Anschluss
- 2c: NO-Anschluss
- 3: Relaisspule
- 3a, 3b: Relaisspulenanschluss
- 4: magnetischer Kern
- 5: Relaisanker
- 6: Schieber
- 7a: COM Kontaktpille
- 7b: NC-Kontaktpille
- 7c: NO-Kontaktpille
- 8: Ansteuerung
- 9a, 9b, 9c: Lastanschluss
- 10: Relais
- 11a, 11b: Steueranschluss
- 11c: Ausgangsanschluss
- 11d: Versorgungsanschluss
- 12, 13: Last
- 100: Kontaktüberwachungseinrichtung
- 110: Signalgenerator
- 110-1: erste Signalgeneratoreinrichtung
- 110-2: zweite Signalgeneratoreinrichtung
- 111: Transistor
- 112, 113: Widerstand
- 114: Emitterwiderstand
- 115, 116, 117: Kondensator
- 118: Abgriff
- 120: Koppeleinrichtung
- 120-1: erstes Koppelelement
- 120-2: zweites Koppelelement
- 121: erste Induktivität
- 122: zweite Induktivität
- 130: Sensierschaltung
- 131: erste Impedanz
- 132: zweite Impedanz
- 132a: zweiter Widerstand
- 132b: zweiter Kondensator
- 133: dritte Impedanz
- 133a: dritter Widerstand
- 133b: dritter Kondensator
- 134: vierte Impedanz
- 135: fünfte Impedanz
- 136: sechste Impedanz
- 137: siebte Impedanz
- 137a: siebte Induktivität
- 137b: siebte Kapazität
- 138: achte Impedanz
- 138a: achte Induktivität
- 138b: achte Kapazität
- 140: Auswerteeinrichtung
- 141, 142: Kondensator
- 143, 144: Diode
- 145: Widerstand

## Patentansprüche

1. Kontaktüberwachungseinrichtung (100) zur Überwachung eines elektrischen, dreipoligen Wechslerkontakts (2), umfassend:
- einen Signalgenerator (110), der ausgebildet ist, ein, vorzugsweise hochfrequentes, Überwachungssignal (S_{Ü}) zu erzeugen;
- eine, vorzugsweise induktive, Koppeleinrichtung (120), welche dem Signalgenerator (110) nachgeschaltet ist;
- eine Sensierschaltung (130), welche der Koppeleinrichtung (120) nachgeschaltet ist und an den Wechslerkontakt (2) gekoppelt oder koppelbar ist;
wobei mittels der, über die Koppeleinrichtung (120) mit dem Signalgenerator (110) gekoppelten, Sensierschaltung (130) die Überwachungssignalerzeugung des Signalgenerators (110) und damit das Überwachungssignal (S_{Ü}) und/oder ein vom Überwachungssignal (S_{Ü}) abgeleitetes Signal in Abhängigkeit einer Schaltstellung des Wechslerkontakts (2) veränderbar ist;
- eine Auswerteeinrichtung (140), welche ausgebildet ist, das Überwachungssignal (S_{Ü}) und/oder das vom Überwachungssignal (S_{Ü}) abgeleitete Signal und/oder eine Änderung des Überwachungssignals (S_{Ü}) und/oder eine Änderung des vom Überwachungssignal (S_{Ü}) abgeleiteten Signals zu erfassen, um dadurch den Wechslerkontakt (2) zu überwachen,
**dadurch gekennzeichnet, dass**
die Sensierschaltung (130) ausgebildet ist, das Überwachungssignal (S_{Ü}) und/oder das vom Überwachungssignal (S_{Ü}) abgeleitete Signal für zumindest drei, vorzugsweise vier, verschiedene Schalterstellungen des Wechslerkontakts (2) unterschiedlich zu verändern,
die Sensierschaltung (130) eine oder mehrere Impedanzen (131 - 138) umfasst und ausgebildet ist, mit dem Wechslerkontakt (2) eine, mit der Schalterstellung des Wechslerkontakts (2) variierende, Gesamtimpedanz an der Koppeleinrichtung (120) bereitzustellen.

2. Kontaktüberwachungseinrichtung (100) nach Anspruch 1, **dadurch gekennzeichnet, dass** die Sensierschaltung (130) ausgebildet ist, eine Amplitude, eine Frequenz, eine Phasenlage, ein Abklingverhalten, eine Laufzeit und/oder eine Signalform des Überwachungssignals (S_{Ü}) und/oder des vom Überwachungssignal (S_{Ü}) abgeleiteten Signals in Abhängigkeit der Schalterstellung des Wechslerkontakts (2) zu verändern.

3. Kontaktüberwachungseinrichtung (100) nach einem der vorherigen Ansprüche, **dadurch gekennzeichnet, dass** der Wechslerkontakt (2) einen COM-Anschluss (2a), einen NC-Anschluss (2b) und einen NO-Anschluss (2c) umfasst und dass die Sensierschaltung (130) ausgebildet ist, das Überwachungssignal (S_{Ü}) und/oder das vom Überwachungssignal (S_{Ü}) abgeleitete Signal für zumindest drei, vorzugsweise vier, besonders bevorzugt alle der folgenden Schalterstellungen jeweils unterschiedlich zu verändern:
(a) keine Verbindung zwischen COM-, NC- und NO-Anschluss (2a, 2b, 2c);
(b) nur der COM-Anschluss (2a) und der NC-Anschluss (2b) sind verbunden;
(c) nur der COM-Anschluss (2a) und der NO-Anschluss (2c) sind verbunden;
(d) nur der NC-Anschluss (2b) und der NO-Anschluss (2c) sind verbunden; und
(e) COM-, NC- und NO-Anschluss (2a, 2b, 2c) sind verbunden.

4. Kontaktüberwachungseinrichtung (100) nach einem der vorherigen Ansprüche, **dadurch gekennzeichnet, dass** die Sensierschaltung (130) ausgebildet ist, für zumindest drei, vorzugsweise vier, besonders bevorzugt fünf Schalterstellungen des Wechslerkontakts (2) jeweils eine unterschiedliche Gesamtimpedanz an der Koppeleinrichtung (120) bereitzustellen.

5. Kontaktüberwachungseinrichtung (100) nach einem der vorherigen Ansprüche, **dadurch gekennzeichnet, dass** die Sensierschaltung (130):
(a) eine erste Impedanz (131), vorzugsweise in Form einer Reihenschaltung aus einem ersten Widerstand und einer ersten Kapazität, umfasst, die mit einem Anschluss des Wechslerkontakts (2) gekoppelt ist; und/oder
(b) eine zweite Impedanz (132), vorzugsweise in Form einer Reihenschaltung aus einem zweiten Widerstand (132a) und einer zweiten Kapazität (132b), umfasst, die mit einem weiteren Anschluss des Wechslerkontakts (2) gekoppelt ist; und/oder
(c) eine dritte Impedanz (133), vorzugsweise in Form einer Reihenschaltung aus einem dritten Widerstand (133a) und einer dritten Kapazität (133b), umfasst, die mit einem weiteren Anschluss des Wechslerkontakts (2) gekoppelt ist.

6. Kontaktüberwachungseinrichtung (100) nach einem der vorherigen Ansprüche, **dadurch gekennzeichnet, dass** die Sensierschaltung (130) eine bis drei Impedanzen (134, 135, 136) umfasst, wobei die jeweilige Impedanz (134, 135, 136) jeweils einem Anschluss des Wechslerkontakts (2) nachgeschaltet ist, um hochfrequente Signale zu dämpfen, welche mittels der Koppeleinrichtung (120) am Wechslerkontakt (2) und/oder an einer an den Wechslerkontakt (2) gekoppelten elektrischen Last und/oder Spannungsquelle anliegen; optional wobei
dass die Sensierschaltung (130) zumindest eine weitere Impedanz (137, 138), vorzugsweise jeweils in Form einer Reihenschaltung aus einer Induktivität (137a, 138a) und einer Kapazität (137b, 138b), umfasst, wobei die zumindest eine weitere Impedanz (137, 138) jeweils zwischen zwei Anschlüssen des Wechslerkontakts (2) geschaltet ist, um hochfrequente Signale zwischen den Anschlüssen des Wechslerkontakts (2) zu dämpfen.

7. Kontaktüberwachungseinrichtung (100) nach einem der vorherigen Ansprüche, **dadurch gekennzeichnet, dass** die Koppeleinrichtung (120) entweder
(a) ein induktiver Übertrager ist, oder
(b) einen Transformator umfasst, welcher eine erste Induktivität und eine zweite Induktivität aufweist, wobei die erste Induktivität mit der zweiten Induktivität induktiv gekoppelt ist, oder
(c) ausgebildet ist, den Signalgenerator (110) und die Sensierschaltung (130) galvanisch zu trennen, oder
(d) aus mindestens zwei elektromagnetisch gekoppelten Antennen ausgebildet ist, oder
(e) aus mindestens zwei Kapazitäten, vorzugsweise als Leiterplattenkondensatoren ausgeführt, ausgebildet ist,
optional wobei die Merkmale (a), (b) und (c) oder die Merkmale (a), (c) und (d) oder die Merkmale (c) und (e) paarweise oder vollständig miteinander kombinierbar sind.

8. Kontaktüberwachungseinrichtung (100) nach einem der vorherigen Ansprüche, **dadurch gekennzeichnet,**
(a) **dass** der Signalgenerator (110) ein Hochfrequenzgenerator ist, der ausgebildet ist, ein hochfrequentes Überwachungssignal (S_{Ü}) zu erzeugen; und/oder
(b) **dass** der Signalgenerator (110) eine Colpitts-Oszillatorschaltung umfasst; und/oder
(c) **dass** der Signalgenerator (110) über die Koppeleinrichtung (120) und die Sensierschaltung (130), beispielsweise parallel, an den Wechslerkontakt (2) angeschaltet ist.

9. Kontaktüberwachungseinrichtung (100) nach einem der vorherigen Ansprüche, **dadurch gekennzeichnet, dass** der Signalgenerator (110) einen Abgriff (118) aufweist und ausgebildet ist, über den Abgriff (118) der Auswerteeinrichtung (140) das Überwachungssignal (S_{Ü}) und/oder das vom Überwachungssignal (S_{Ü}) abgeleitete Signal bereitzustellen.

10. Kontaktüberwachungseinrichtung (100) nach einem der vorherigen Ansprüche, **dadurch gekennzeichnet, dass** das Überwachungssignal (S_{Ü}) zumindest ein erstes Überwachungsteilsignal (S_{Ü1}) und ein zweites Überwachungsteilsignal (S_{Ü2}) umfasst und dass mittels der Sensierschaltung (130) das erste Überwachungsteilsignal (S_{Ü1}) und/oder ein vom ersten Überwachungsteilsignal (S_{Ü1}) abgeleitetes Signal in Abhängigkeit einer Schaltstellung einer ersten Anschlussteilmenge des Wechslerkontakts (2) und das zweite Überwachungsteilsignal (S_{Ü2}) und/oder ein vom zweiten Überwachungsteilsignal (S_{Ü2}) abgeleitetes Signal in Abhängigkeit einer Schaltstellung einer zweiten Anschlussteilmenge des Wechslerkontakts (2) veränderbar ist.

11. Kontaktüberwachungseinrichtung (100) nach Anspruch 10, **dadurch gekennzeichnet,**
(a) **dass** der Signalgenerator (110) eine erste Signalgeneratoreinrichtung (110-1) zur Erzeugung des ersten Überwachungsteilsignals (S_{Ü1}) und eine zweite Signalgeneratoreinrichtung (110-2) zur Erzeugung des zweiten Überwachungsteilsignals (S_{Ü2}) umfasst; und/oder
(b) **dass** die Koppeleinrichtung (120) ein erstes Koppelelement (120-1) zur Kopplung der ersten Signalgeneratoreinrichtung (110-1) an die Sensierschaltung (130) und ein zweites Koppelelement (120-2) zur Kopplung der zweiten Signalgeneratoreinrichtung (110-2) an die Sensierschaltung (130) umfasst; und/oder
(c) **dass** die Sensierschaltung (130) ausgebildet ist, das erste Überwachungsteilsignal (S_{Ü1}) an eine erste Anschlussteilmenge des Wechslerkontakts (2) zu koppeln und das zweite Überwachungsteilsignal (S_{Ü2}) an eine zweite Anschlussteilmenge zu koppeln.

12. Kontaktüberwachungseinrichtung (100) nach einem der vorherigen Ansprüche, **dadurch gekennzeichnet, dass** die Auswerteeinrichtung (140) ausgebildet ist, in Abhängigkeit des Überwachungssignals (S_{Ü}) und/oder des vom Überwachungssignal (S_{Ü}) abgeleiteten Signals ein Zustandssignal (S_{Z}) auszugeben, welches die Schalterstellungen des Wechslerkontakts (2) anzeigt.

13. Kontaktüberwachungseinrichtung (100) nach einem der vorherigen Ansprüche, **dadurch gekennzeichnet, dass** die Auswerteeinrichtung (140) ausgebildet ist, ein Schaltsignal (S_{S}) zum Schalten des Wechslerkontakts (2) zu erfassen und in Abhängigkeit des Schaltsignals (S_{S}) und der Änderung des Überwachungssignals (S_{Ü}) und/oder der Änderung des vom Überwachungssignal (S_{Ü}) abgeleiteten Signals ein Kontrollsignal (S_{K}) auszugeben, welches anzeigt, ob der Wechslerkontakt (2) entsprechend dem Schaltsignal (S_{S}) geschaltet ist,
optional dass die Auswerteeinrichtung (140) ausgebildet ist, mit dem Empfangen des Schaltsignals (S_{S}) das Überwachungssignal (S_{Ü}) und/oder das vom Überwachungssignal (Sü) abgeleitete Signal und/oder die Änderung des Überwachungssignals (S_{Ü}) und/oder des vom Überwachungssignal (S_{Ü}) abgeleiteten Signals innerhalb eines vorbestimmten Zeitintervalls zu erfassen, um festzustellen, ob der Wechslerkontakt (2) innerhalb des vorbestimmten Zeitintervalls entsprechend dem Schaltsignal (S_{S}) geschaltet ist.

14. Kontaktüberwachungseinrichtung (100) nach einem der vorherigen Ansprüche, **dadurch gekennzeichnet, dass** die Kontaktüberwachungseinrichtung (100) eine Ansteuerung (8) zur Steuerung des Schaltzustands des Wechslerkontakts (2) umfasst.

15. System, umfassend:
- ein Relais (10) mit einem Wechslerkontakt (2) und
- einen Relais-Sockel zur Aufnahme des Relais (10),
**dadurch gekennzeichnet,**
**dass** das System ferner eine Kontaktüberwachungseinrichtung (100) nach einem der Ansprüche 1 bis 14 zur Überwachung des Wechslerkontakts (2) des Relais (10) umfasst, und dass die Kontaktüberwachungseinrichtung (100) Teil des Relais-Sockels ist.

## Claims

1. **A contact-monitoring device (100) for monitoring an electrical, three-pole changeover contact (2), comprising:**
- a signal generator (110) that is configured to generate a preferably high-frequency monitoring signal (S_{Ü});
- a preferably inductive coupling device (120), which is arranged downstream of the signal generator (110);
- a sensing circuit (130), which is arranged downstream of the coupling device (120) and is coupled or couplable to the changeover contact (2);
wherein by means of the sensing circuit (130), which is coupled to the signal generator (110) via the coupling device (120), the monitoring-signal generation of the signal generator (110) and thus the monitoring signal (S_{Ü}) and/or a signal derived from the monitoring signal (S_{Ü}) is changeable depending on a switching position of the changeover contact (2);
- an evaluation device (140), which is configured to detect the monitoring signal (S_{Ü}) and/or the signal derived from the monitoring signal (S_{Ü}) and/or a change in the monitoring signal (S_{Ü}) and/or a change in the signal derived from the monitoring signal (S_{Ü}) in order thereby to monitor the changeover contact (2),
**characterized in that**
the sensing circuit (130) is configured to change the monitoring signal (S_{Ü}) and/or the signal derived from the monitoring signal (S_{Ü}) differently for at least three, preferably four, different switching positions of the changeover contact (2),
and the sensing circuit (130) comprises one or more impedances (131 - 138) and is configured to provide, together with the changeover contact (2), a total impedance at the coupling device (120) that varies with the switching position of the changeover contact (2).

2. **The contact-monitoring device (100) according to claim 1, characterized in that** the sensing circuit (130) is configured to change an amplitude, a frequency, a phase angle, a decay behavior, a propagation time and/or a signal shape of the monitoring signal (S_{Ü}) and/or the signal derived from the monitoring signal (S_{Ü}) in dependence on the switching position of the changeover contact (2).

3. **The contact-monitoring device (100) according to one of the preceding claims, characterized in that** the changeover contact (2) comprises a COM terminal (2a), an NC terminal (2b), and an NO terminal (2c), and that the sensing circuit (130) is configured to change the monitoring signal (S_{Ü}) and/or the signal derived from the monitoring signal (S_{Ü}) differently for at least three, preferably four, particularly preferably all, of the following switching positions:
(a) no connection between the COM, NC, and NO terminals (2a, 2b, 2c);
(b) only the COM terminal (2a) and the NC terminal (2b) are connected;
(c) only the COM terminal (2a) and the NO terminal (2c) are connected;
(d) only the NC terminal (2b) and the NO terminal (2c) are connected; and
(e) COM, NC, and NO terminals (2a, 2b, 2c) are connected.

4. **The contact-monitoring device (100) according to one of the preceding claims, characterized in that** the sensing circuit (130) is configured to provide a different total impedance at the coupling device (120) for at least three, preferably four, particularly preferably five switching positions of the changeover contact (2).

5. **The contact-monitoring device (100) according to one of the preceding claims, characterized in that** the sensing circuit (130):
(a) comprises a first impedance (131), preferably in the form of a series circuit made of a first resistor and a first capacitance, which is coupled to one terminal of the changeover contact (2); and/or
(b) comprises a second impedance (132), preferably in the form of a series circuit made of a second resistor (132a) and a second capacitance (132b), which is coupled to another terminal of the changeover contact (2); and/or
(c) comprises a third impedance (133), preferably in the form of a series circuit made of a third resistor (133a) and a third capacitance (133b), which is coupled to another terminal of the changeover contact (2).

6. **The contact-monitoring device (100) according to one of the preceding claims, characterized in that** the sensing circuit (130) comprises one to three impedances (134, 135, 136), wherein each impedance (134, 135, 136) is arranged downstream of one terminal of the changeover contact (2) in order to attenuate high-frequency signals which, by means of the coupling device (120), are applied to the changeover contact (2) and/or to an electrical load and/or a voltage source coupled to the changeover contact (2); optionally wherein
the sensing circuit (130) comprises at least one further impedance (137, 138), preferably each in the form of a series circuit consisting of an inductance (137a, 138a) and a capacitance (137b, 138b), wherein the at least one further impedance (137, 138) is respectively connected between two terminals of the changeover contact (2) in order to attenuate high-frequency signals between the terminals of the changeover contact (2).

7. **The contact-monitoring device (100) according to one of the preceding claims, characterized in that** the coupling device (120) is either
(a) an inductive transformer, or
(b) comprises a transformer having a first inductance and a second inductance, wherein the first inductance is inductively coupled to the second inductance, or
(c) is configured to galvanically isolate the signal generator (110) and the sensing circuit (130), or
(d) is formed from at least two electromagnetically coupled antennas, or
(e) is formed from at least two capacitors, preferably implemented as printedcircuit-board capacitors,
optionally wherein features (a), (b), and (c) or features (a), (c), and (d) or features (c) and (e) can be combined pairwise or all together.

8. **The contact-monitoring device (100) according to one of the preceding claims, characterized in that**
(a) the signal generator (110) is a high-frequency generator configured to generate a high-frequency monitoring signal (S_{Ü}); and/or
(b) the signal generator (110) comprises a Colpitts oscillator circuit; and/or
(c) the signal generator (110) is connected, for example in parallel, to the changeover contact (2) via the coupling device (120) and the sensing circuit (130).

9. **The contact-monitoring device (100) according to one of the preceding claims, characterized in that** the signal generator (110) has a tap (118) and is configured to provide the evaluation device (140) with the monitoring signal (S_{Ü}) and/or the signal derived from the monitoring signal (S_{Ü}) via the tap (118).

10. **The contact-monitoring device (100) according to one of the preceding claims, characterized in that** the monitoring signal (S_{Ü}) comprises at least a first monitoring partial signal (S_{Ü1}) and a second monitoring partial signal (S_{Ü2}), and that, by means of the sensing circuit (130), the first monitoring partial signal (S_{Ü1}) and/or a signal derived from the first monitoring partial signal (S_{Ü1}) is changeable in dependence on a switching position of a first subset of terminals of the changeover contact (2), and the second monitoring partial signal (S_{Ü2}) and/or a signal derived from the second monitoring partial signal (S_{Ü2}) is changeable in dependence on a switching position of a second subset of terminals of the changeover contact (2).

11. **The contact-monitoring device (100) according to claim 10, characterized in that**
(a) the signal generator (110) comprises a first signal generator device (110-1) for generating the first monitoring partial signal (S_{Ü1}) and a second signal generator device (110-2) for generating the second monitoring partial signal (S_{Ü2}); and/or
(b) the coupling device (120) comprises a first coupling element (120-1) for coupling the first signal generator device (110-1) to the sensing circuit (130) and a second coupling element (120-2) for coupling the second signal generator device (110-2) to the sensing circuit (130); and/or
(c) the sensing circuit (130) is configured to couple the first monitoring partial signal (S_{Ü1}) to a first subset of terminals of the changeover contact (2) and to couple the second monitoring partial signal (S_{Ü2}) to a second subset of terminals of the changeover contact (2).

12. **The contact-monitoring device (100) according to one of the preceding claims, characterized in that** the evaluation device (140) is configured to output a state signal (S_{Z}) in dependence on the monitoring signal (S_{Ü}) and/or the signal derived from the monitoring signal (S_{Ü}), said state signal (S_{Z}) indicating the switching positions of the changeover contact (2).

13. **The contact-monitoring device (100) according to one of the preceding claims, characterized in that** the evaluation device (140) is configured to detect a switching signal (S_{S}) for switching the changeover contact (2) and, in dependence on the switching signal (S_{S}) and the change in the monitoring signal (S_{Ü}) and/or the change in the signal derived from the monitoring signal (S_{Ü}), to output a control signal (S_{K}) which indicates whether the changeover contact (2) is switched in accordance with the switching signal (Ss),
optionally that the evaluation device (140) is configured, upon receiving the switching signal (S_{S}), to detect the monitoring signal (S_{Ü}) and/or the signal derived from the monitoring signal (S_{Ü}) and/or the change in the monitoring signal (S_{Ü}) and/or the change in the signal derived from the monitoring signal (S_{Ü}) within a predetermined time interval to determine whether the changeover contact (2) is switched in accordance with the switching signal (S_{S}) within the predetermined time interval.

14. **The contact-monitoring device (100) according to one of the preceding claims, characterized in that** the contact-monitoring device (100) comprises an actuation (8) for controlling the switching state of the changeover contact (2).

15. **A system, comprising:**
- a relay (10) having a changeover contact (2), and
- a relay socket for receiving the relay (10),
**characterized in that**
the system further comprises a contact-monitoring device (100) according to one of claims 1 to 14 for monitoring the changeover contact (2) of the relay (10), and
the contact-monitoring device (100) is part of the relay socket.

## Revendications

1. **Dispositif de surveillance de contact** (100) pour la surveillance d'un contact inverseur tripolaire (2) électrique, comprenant :
- un **générateur de signal** (110), configuré pour générer un **signal de surveillance** (SÜ), de préférence à haute fréquence ;
- un **dispositif de couplage** (120), de préférence inductif, qui est connecté en aval du générateur de signal (110) ;
- un **circuit de détection** (130), qui est connecté en aval du dispositif de couplage (120) et qui est ou peut être couplé au contact inverseur tripolaire (2) ;
dans lequel, au moyen du circuit de détection (130) couplé au générateur de signal (110) via le dispositif de couplage (120), la génération du signal de surveillance par le générateur de signal (110), et donc le signal de surveillance (SÜ) et/ou un signal dérivé du signal de surveillance (SÜ), peut être modifié en fonction d'une **position de commutation** du contact inverseur tripolaire (2) ;
- une **unité d'évaluation** (140), configurée pour détecter le signal de surveillance (SÜ) et/ou le signal dérivé du signal de surveillance (SÜ) et/ou une modification du signal de surveillance (SÜ) et/ou une modification du signal dérivé du signal de surveillance (SÜ), afin de surveiller ainsi le contact inverseur tripolaire (2),
**caractérisé en ce que**
le circuit de détection (130) est configuré pour modifier de manière différente le signal de surveillance (SÜ) et/ou le signal dérivé du signal de surveillance (SÜ) pour au moins trois, de préférence quatre, positions de commutation différentes du contact inverseur tripolaire (2),
le circuit de détection (130) comprend une ou plusieurs **impédances** (131 à 138) et est configuré pour fournir, avec le contact inverseur tripolaire (2), une impédance globale variant selon la position de commutation dudit contact inverseur tripolaire (2) au niveau du dispositif de couplage (120).

2. **Dispositif de surveillance de contact** (100) selon la revendication 1, **caractérisé en ce que** le circuit de détection (130) est configuré pour modifier une amplitude, une fréquence, un déphasage, un comportement d'extinction, un temps de propagation et/ou une forme d'onde du signal de surveillance (SÜ) et/ou du signal dérivé du signal de surveillance (SÜ) en fonction de la position de commutation du contact inverseur tripolaire (2).

3. **Dispositif de surveillance de contact** (100) selon l'une quelconque des revendications précédentes, **caractérisé en ce que** le contact inverseur tripolaire (2) comprend une borne COM (2a), une borne NC (2b) et une borne NO (2c), et **en ce que** le circuit de détection (130) est configuré pour modifier différemment le signal de surveillance (SÜ) et/ou le signal dérivé du signal de surveillance (SÜ) pour au moins trois, de préférence quatre, de manière particulièrement préférée toutes les positions de commutation suivantes :
a) aucune connexion entre les bornes COM, NC et NO (2a, 2b, 2c) ;
b) seules les bornes COM (2a) et NC (2b) sont connectées ;
c) seules les bornes COM (2a) et NO (2c) sont connectées ;
d) seules les bornes NC (2b) et NO (2c) sont connectées ; et
e) les bornes COM, NC et NO (2a, 2b, 2c) sont connectées.

4. **Dispositif de surveillance de contact** (100) selon l'une quelconque des revendications précédentes, **caractérisé en ce que** le circuit de détection (130) est configuré pour fournir, pour au moins trois, de préférence quatre, et de manière particulièrement préférée cinq positions de commutation du contact inverseur tripolaire (2), une impédance globale différente à chaque fois au niveau du dispositif de couplage (120).

5. **Dispositif de surveillance de contact** (100) selon l'une quelconque des revendications précédentes, **caractérisé en ce que** le circuit de détection (130) :
a) comprend une première impédance (131), de préférence sous forme d'un montage en série d'une première résistance et d'une première capacité, qui est couplée à une borne du contact inverseur tripolaire (2) ; et/ou
b) comprend une deuxième impédance (132), de préférence sous forme d'un montage en série d'une deuxième résistance (132a) et d'une deuxième capacité (132b), qui est couplée à une autre borne du contact inverseur tripolaire (2) ; et/ou
c) comprend une troisième impédance (133), de préférence sous forme d'un montage en série d'une troisième résistance (133a) et d'une troisième capacité (133b), qui est couplée à une autre borne du contact inverseur tripolaire (2).

6. **Dispositif de surveillance de contact** (100) selon l'une quelconque des revendications précédentes, **caractérisé en ce que** le circuit de détection (130) comprend une à trois impédances (134, 135, 136), chaque impédance (134, 135, 136) étant connectée en aval d'une borne du contact inverseur tripolaire (2) afin d'atténuer des signaux haute fréquence qui sont présents via le dispositif de couplage (120) sur le contact inverseur tripolaire (2) et/ou sur une charge électrique et/ou sur une source de tension couplée au contact inverseur tripolaire (2) ; optionnellement, dans lequel le circuit de détection (130) comprend au moins une impédance supplémentaire (137, 138), de préférence chacune sous forme d'un montage en série d'une inductance (137a, 138a) et d'une capacité (137b, 138b), ladite au moins une impédance supplémentaire (137, 138) étant à chaque fois connectée entre deux bornes du contact inverseur tripolaire (2) afin d'atténuer des signaux haute fréquence entre lesdites bornes dudit contact inverseur tripolaire (2).

7. **Dispositif de surveillance de contact** (100) selon l'une quelconque des revendications précédentes, **caractérisé en ce que** le dispositif de couplage (120) est soit
a) un transducteur inductif, ou
b) comprend un transformateur qui présente une première inductance et une deuxième inductance, ladite première inductance étant couplée inductivement à ladite deuxième inductance, ou
c) est configuré pour isoler galvaniquement le générateur de signal (110) et le circuit de détection (130), ou
d) est constitué d'au moins deux antennes couplées électromagnétiquement, ou
e) est constitué d'au moins deux capacités, de préférence réalisées sous forme de condensateurs de circuit imprimé,
optionnellement, dans lequel les caractéristiques (a), (b) et (c), ou les caractéristiques (a), (c) et (d), ou les caractéristiques (c) et (e) peuvent être combinées entre elles par paires ou dans leur intégralité.

8. **Dispositif de surveillance de contact** (100) selon l'une quelconque des revendications précédentes, **caractérisé en ce que**
a) le générateur de signal (110) est un générateur haute fréquence, configuré pour générer un signal de surveillance (SÜ) haute fréquence ; et/ou
b) le générateur de signal (110) comprend un circuit oscillateur de Colpitts ; et/ou
c) le générateur de signal (110) est raccordé, par exemple en parallèle, au contact inverseur tripolaire (2) via le dispositif de couplage (120) et le circuit de détection (130).

9. **Dispositif de surveillance de contact** (100) selon l'une quelconque des revendications précédentes, **caractérisé en ce que** le générateur de signal (110) comporte une prise (118) et est configuré pour fournir, via ladite prise (118) à l'unité d'évaluation (140), le signal de surveillance (SÜ) et/ou le signal dérivé du signal de surveillance (SÜ).

10. **Dispositif de surveillance de contact** (100) selon l'une quelconque des revendications précédentes, **caractérisé en ce que** le signal de surveillance (SÜ) comprend au moins un premier sous-signal de surveillance (SÜ1) et un deuxième sous-signal de surveillance (SÜ2), et **en ce que**, au moyen du circuit de détection (130), le premier sous-signal de surveillance (SÜ1) et/ou un signal dérivé du premier sous-signal de surveillance (SÜ1) peut être modifié en fonction d'une position de commutation d'un premier sous-ensemble de bornes du contact inverseur tripolaire (2), et le deuxième sous-signal de surveillance (SÜ2) et/ou un signal dérivé du deuxième sous-signal de surveillance (SÜ2) peut être modifié en fonction d'une position de commutation d'un deuxième sous-ensemble de bornes dudit contact inverseur tripolaire (2).

11. **Dispositif de surveillance de contact** (100) selon la revendication 10, **caractérisé en ce que**
a) le générateur de signal (110) comprend une première unité de génération de signal (110-1) pour la production du premier sous-signal de surveillance (SÜ1) et une deuxième unité de génération de signal (110-2) pour la production du deuxième sous-signal de surveillance (SÜ2) ; et/ou
b) le dispositif de couplage (120) comprend un premier élément de couplage (120-1) pour coupler la première unité de génération de signal (110-1) au circuit de détection (130) et un deuxième élément de couplage (120-2) pour coupler la deuxième unité de génération de signal (110-2) audit circuit de détection (130) ; et/ou
c) le circuit de détection (130) est configuré pour coupler le premier sous-signal de surveillance (SÜ1) à un premier sous-ensemble de bornes du contact inverseur tripolaire (2) et le deuxième sous-signal de surveillance (SÜ2) à un deuxième sous-ensemble de bornes dudit contact inverseur tripolaire (2).

12. **Dispositif de surveillance de contact** (100) selon l'une quelconque des revendications précédentes, **caractérisé en ce que** l'unité d'évaluation (140) est configurée pour délivrer, en fonction du signal de surveillance (SÜ) et/ou du signal dérivé du signal de surveillance (SÜ1), un signal d'état (SZ) qui indique les positions de commutation du contact inverseur tripolaire (2).

13. **Dispositif de surveillance de contact** (100) selon l'une quelconque des revendications précédentes, **caractérisé en ce que** l'unité d'évaluation (140) est configurée pour détecter un signal de commutation (SS) destiné à commuter le contact inverseur tripolaire (2), et pour délivrer, en fonction du signal de commutation (SS) et de la modification du signal de surveillance (SÜ) et/ou de la modification du signal dérivé du signal de surveillance (SÜ1), un signal de contrôle (SK) indiquant si le contact inverseur tripolaire (2) est commuté conformément audit signal de commutation (SS),
optionnellement, dans lequel l'unité d'évaluation (140) est configurée, dès la réception du signal de commutation (SS), pour détecter le signal de surveillance (SÜ) et/ou le signal dérivé du signal de surveillance (SÜ1) et/ou la modification du signal de surveillance (SÜ) et/ou la modification du signal dérivé du signal de surveillance (SÜ1) dans un intervalle de temps prédéterminé, afin de déterminer si le contact inverseur tripolaire (2) est commuté conformément au signal de commutation (SS) à l'intérieur dudit intervalle de temps prédéterminé.

14. **Dispositif de surveillance de contact** (100) selon l'une quelconque des revendications précédentes, **caractérisé en ce que** le dispositif de surveillance de contact (100) comprend un dispositif de pilotage (8) pour commander l'état de commutation du contact inverseur tripolaire (2).

15. **Système,** comprenant :
- un **relais** (10) avec un contact inverseur tripolaire (2), et
- un socle de relais pour le montage dudit relais (10),
**caractérisé en ce que**
le système comprend en outre un dispositif de surveillance de contact
(100) selon l'une quelconque des revendications 1 à 14 pour la surveillance du contact inverseur tripolaire (2) dudit relais (10), et le dispositif de surveillance de contact (100) fait partie dudit socle de relais.
